# EUROPEAN PATENT APPLICATION

(11) **EP 4 832 672 A1**
(43) Date of publication of application: **28.10.2026**
(21) Application number: 24908351.0
(22) Date of filing: 18.12.2024
(51) Int. Cl.: H05K 1/11, H05K 1/02, H05K 1/18, H01L 23/538, H05K 3/28

(54) **CIRCUIT BOARD, AND SEMICONDUCTOR PACKAGE COMPRISING SAME**

(30) Priority: 19.12.2023 KR 20230185812
(71) Applicant: LG Innotek Co., Ltd., Seoul 07796 (KR)
(72) Inventor: KWON, Ki Tae, Seoul 07796 (KR); CHO, Hyun Dong, Seoul 07796 (KR); LEE, Dong Keon, Seoul 07796 (KR); CHOI, So Hee, Seoul 07796 (KR)
(74) Representative: Plasseraud IP
(86) International application number: PCT/KR2024/097119
(87) International publication number: WO 2025/136047

(57) **Abstract**

A circuit board according to an embodiment comprises a first insulating layer; a second insulating layer disposed on the first insulating layer and including a cavity; a protective layer disposed on the second insulating layer; and a via electrode including an upper surface located on a same plane as an upper surface of the second insulating layer, and penetrating at least a partial region of the second insulating layer from the upper surface of the via electrode toward a lower surface of the second insulating layer, wherein the via electrode includes a through hole penetrating at least a partial region of the via electrode from the upper surface of the via electrode toward the lower surface of the second insulating layer, and the through hole of the via electrode overlaps the cavity provided in the second insulating layer in a horizontal direction.

## Description

### Technical Field

An embodiment relates to a circuit board and a semiconductor package substrate including the same.

### Background Art

As performance of electrical/electronic products is enhanced, technologies for arranging a greater number of semiconductor devices on a semiconductor package substrate of limited size have been proposed and studied. However, since a general semiconductor package is based on mounting a single semiconductor device, there is a limitation in obtaining desired performance.

Accordingly, recently, semiconductor packages in which a plurality of semiconductor devices are arranged using a plurality of substrates have been provided. Such semiconductor packages have a structure in which the plurality of semiconductor devices are connected to each other on the substrate in a horizontal direction and/or a vertical direction. Accordingly, the semiconductor package has advantages in that a mounting area of the semiconductor devices is efficiently used and high-speed signals can be transmitted through a short signal transmission path between the semiconductor devices.

In addition, semiconductor packages applied to products providing Internet of Things (IoT), autonomous vehicles, high-performance servers, and the like are expanding in concept to semiconductor chiplets as the number of semiconductor devices and/or the size of each semiconductor device increases according to a trend toward higher integration, or as functional portions of the semiconductor devices are divided.

Meanwhile, as the number of semiconductor devices and/or semiconductor chiplets mounted on a semiconductor package increases, an area of the semiconductor package tends to increase.

Accordingly, as the area of the semiconductor package becomes wider, the semiconductor package has a problem in that the semiconductor package is more greatly warped. In addition, as the number of the plurality of semiconductor devices and/or semiconductor chiplets increases, heat generation becomes more severe, and accordingly, there is a problem in that heat dissipation characteristics should be further improved.

### Disclosure

### Technical Problem

An embodiment provides a circuit board having a new structure and a semiconductor package including the same.

In addition, the embodiment provides a circuit board having improved heat dissipation characteristics and a semiconductor package including the same.

In addition, the embodiment provides a circuit board having improved warpage characteristics and a semiconductor package including the same.

Technical problems to be solved by the proposed embodiments are not limited to the above-mentioned technical problems, and other technical problems not mentioned may be clearly understood by those skilled in the art to which the embodiments proposed from the following descriptions belong.

### Technical Solution

A circuit board according to an embodiment comprises a first insulating layer; a second insulating layer disposed on the first insulating layer and including a cavity; a protective layer disposed on the second insulating layer; and a via electrode including an upper surface located on a same plane as an upper surface of the second insulating layer, and penetrating at least a partial region of the second insulating layer from the upper surface of the via electrode toward a lower surface of the second insulating layer, wherein the via electrode includes a through hole penetrating at least a partial region of the via electrode from the upper surface of the via electrode toward the lower surface of the second insulating layer, and the through hole of the via electrode overlaps the cavity provided in the second insulating layer in a horizontal direction.

In addition, the second insulating layer includes a first portion disposed at an outer side of the via electrode, and a second portion disposed in the through hole of the via electrode.

In addition, the through hole is provided in plurality and spaced apart from each other in the via electrode in a first horizontal direction and a second horizontal direction different from the first horizontal direction.

In addition, the second insulating layer includes a via hole penetrating at least a partial region of the second portion from an upper surface of the second portion toward a lower surface of the second portion, and the circuit board further comprises a sub via electrode disposed in the via hole of the second insulating layer.

In addition, the second portion of the second insulating layer surrounds the sub via electrode and is provided between an inner side surface of the through hole of the via electrode and an outer side surface of the sub via electrode.

In addition, the through hole of the via electrode is spaced apart from a perimeter of the upper surface of the via electrode.

In addition, the perimeter of the upper surface of the via electrode includes a plurality of curved portions and a plurality of linear portions provided between the plurality of curved portions, and the plurality of curved portions and the plurality of linear portions have a step along the horizontal direction.

In addition, the perimeter of the upper surface of the via electrode includes a plurality of first linear portions and a plurality of second linear portions provided between the plurality of first linear portions, and the plurality of first linear portions and the plurality of second linear portions have a step along the horizontal direction.

In addition, a sidewall of the cavity of the second insulating layer includes a first sidewall connected to the upper surface of the second insulating layer and having a first inclination, and a second sidewall provided between the lower surface of the second insulating layer and the first sidewall and having a second inclination different from the first inclination.

In addition, the second insulating layer includes a second-first insulating layer disposed on the first insulating layer, and a second-second insulating layer disposed on the second-first insulating layer, and the cavity and the via electrode are provided in at least one of the second-first insulating layer and the second-second insulating layer.

In addition, the via electrode includes a first via electrode provided in the second-first insulating layer and including a plurality of through holes, and a second via electrode disposed in the second-second insulating layer to overlap the first via electrode in a vertical direction and including a plurality of through holes.

In addition, the second-first insulating layer includes a via hole overlapping the via electrode in a vertical direction, the second-second insulating layer includes a protrusion disposed in the via hole of the second-first insulating layer, and the via electrode is provided to penetrate from an upper surface of the second-second insulating layer to a lower surface of the protrusion of the second-second insulating layer.

In addition, the cavity includes a first portion provided in the second-first insulating layer and a second portion provided in the second-second insulating layer, and a width in a horizontal direction of the first portion of the cavity is different from a width in the horizontal direction of the second portion of the cavity.

In addition, the circuit board further comprises a lower pad connected to a lower surface of the via electrode; and an upper pad connected to an upper surface of the via electrode, wherein a lower surface of the upper pad includes a first lower surface contacting the upper surface of the via electrode, a second lower surface contacting an upper surface of the sub via electrode, and a third lower surface provided between the first lower surface and the second lower surface and contacting the second portion of the second insulating layer.

In addition, the lower pad includes a through hole overlapping the through hole of the via electrode in a vertical direction and penetrating the lower pad.

In addition, the lower pads are provided in plurality and spaced apart in a horizontal direction, and a separation space between the plurality of lower pads overlaps the through hole of the via electrode in a vertical direction.

In addition, the cavity is provided in the second-second insulating layer, the circuit board further comprises a third via electrode provided in the second-first insulating layer to overlap the cavity in a vertical direction, and the third via electrode includes a plurality of through holes spaced apart from each other along a horizontal direction and penetrating the third via electrode.

Meanwhile, a circuit board according to embodiments comprises: a core layer; a first insulating layer disposed on the core layer; a second insulating layer disposed on the first insulating layer; and a via electrode penetrating the second insulating layer, wherein the via electrode includes a plurality of through holes spaced apart in a first horizontal direction and a second horizontal direction different from the first horizontal direction, and a planar shape of the via electrode has a mesh shape in which positions at which the plurality of through holes are provided are opened.

In addition, the second insulating layer includes a second-first insulating layer disposed on the first insulating layer and a second-second insulating layer disposed on the second-first insulating layer, at least one of the second-first insulating layer and the second-second insulating layer includes a cavity, and the via electrode includes at least one of a first via electrode provided in the second-second insulating layer and overlapping the cavity in a horizontal direction; a second via electrode provided in the second-first insulating layer and overlapping the cavity in a horizontal direction or overlapping the first via electrode in a vertical direction; and a third via electrode provided in the second-first insulating layer and overlapping the cavity in a vertical direction or overlapping the second via electrode in a horizontal direction.

### Advantageous Effects

The circuit board according to embodiments may provide a via electrode having improved physical reliability and/or electrical reliability and improved heat dissipation characteristics and/or electrical characteristics.

That is, the circuit board may include a first insulating layer and a second insulating layer disposed on the first insulating layer. The second insulating layer may include a cavity, and the via electrode may penetrate at least a partial region of the second insulating layer to overlap the cavity of the second insulating layer in a horizontal direction. In this case, the via electrode may include a through hole. The through hole may penetrate the via electrode from an upper surface of the via electrode toward a lower surface of the via electrode. In addition, the through hole provided in the via electrode may be filled with the second insulating layer. The through hole provided in the via electrode may function to control a planar area of the via electrode, and thus, processability in a process of filling a via hole corresponding to the via electrode with a conductive material may be improved, thereby preventing a void from being provided in the via electrode. For example, an inner side surface of the through hole of the via electrode may function as a plating bridge in a process of filling the via hole provided in the second insulating layer with a conductive material, and accordingly, the via hole may be uniformly filled with the conductive material overall. Furthermore, the through hole provided in the via electrode may function to control a density of other via electrodes provided in a same layer by adjusting the planar area of the via electrode, and as a result, a warpage problem of the circuit board that may occur due to a difference in density between via electrodes provided at mutually symmetrical positions may be solved.

In addition, the through holes provided in the via electrode may be provided in plurality. Preferably, the through holes provided in the via electrode may include a plurality of through holes spaced apart in a first horizontal direction and a plurality of through holes spaced apart in a second horizontal direction different from the first horizontal direction. Accordingly, compared to a plurality of circular via electrodes and/or bar-shaped via electrodes spaced apart in the first and second horizontal directions according to a prior art, a planar area of the via electrode within a limited space may be maximized, and accordingly, heat dissipation characteristics of the circuit board and/or semiconductor package may be further improved by the via electrode.

In addition, as the via electrode is provided with the plurality of through holes spaced apart in the first and second horizontal directions, a uniform conductive material filling process may proceed in all via holes provided in the circuit board, thereby further improving mechanical reliability and/or electrical reliability of the via electrode.

In addition, a semiconductor device may be disposed on the via electrode. Accordingly, the via electrode may overlap the semiconductor device disposed in the cavity in a vertical direction, and thus, heat dissipation characteristics of the semiconductor device may be further improved so that the semiconductor device may operate more stably.

In addition, a perimeter of the upper surface of the via electrode may include a step, and accordingly, a contact area between the first insulating layer and the via electrode may be greatly increased. Accordingly, the embodiment may secure adhesion between the first insulating layer and the via electrode, thereby improving mechanical reliability and/or electrical reliability of the circuit board and the semiconductor package including the same.

In addition, the via electrode may include a first via electrode overlapping the cavity in a horizontal direction and a second via electrode overlapping the cavity in a vertical direction. The first via electrode may be provided in the second insulating layer, and the second via electrode may be provided in the first insulating layer including the cavity. Accordingly, the embodiment may more efficiently dissipate heat generated from the semiconductor device disposed in the cavity, and thus, the semiconductor device may operate more stably.

In addition, as an example, the first insulating layer may include a thermosetting material, and the second insulating layer may include a photocurable material. As another example, each of the first and second insulating layers may include a photocurable material. In this case, when the above-described via electrode is provided in an insulating layer including the photocurable material, a degree of freedom in design of the via electrode may be further improved. That is, in the insulating layer including the photocurable material, it is possible to form the via hole through exposure and development processes, and the degree of freedom in design may be improved compared to a processing method such as a laser process. Furthermore, embodiments make it possible to form the via electrode in a design capable of implementing optimal heat dissipation performance in consideration of an arrangement position of the semiconductor device disposed on the circuit board, and accordingly, heat dissipation characteristics of the circuit board and/or semiconductor package may be further improved. Therefore, the semiconductor device may operate more stably.

In addition, the via electrode is provided to penetrate at least a partial region of the second insulating layer, and through this, overlaps the cavity provided in the second insulating layer in a horizontal direction. In this case, when the cavity is provided in the second insulating layer, a planar area of the second insulating layer in a first buildup layer and a planar area of the second insulating layer in a second buildup layer may be different from each other, and the circuit board may be greatly warped in a specific direction due to a difference between the planar areas thereof. Accordingly, by providing the via electrode overlapping the cavity in a horizontal direction, a difference between the planar area of the second insulating layer in the first buildup layer and the planar area of the second insulating layer in the second buildup layer may be alleviated by the via electrode, and thus, it is possible to prevent the circuit board from being greatly warped in a specific direction. Furthermore, the via electrode may overlap the semiconductor device disposed in the cavity in a horizontal direction, and thus, rigidity of the circuit board in a region overlapping the semiconductor device in a horizontal direction may be improved so that the semiconductor device may operate more stably.

In addition, the second insulating layer may be provided as a plurality of layers, and at least one via electrode may be provided to commonly penetrate the plurality of second insulating layers. For example, the second insulating layer may include a second-first insulating layer and a second-second insulating layer. In addition, the second-first insulating layer may include a via hole, and the second-second insulating layer may include a protrusion filling the via hole of the second-first insulating layer. In addition, at least one among the via electrodes provided in the second-second insulating layer may be provided to penetrate from an upper surface of the second-second insulating layer to a lower surface of the protrusion of the second-second insulating layer. Accordingly, embodiments may simplify a manufacturing process of the circuit board and improve product yield. Furthermore, embodiments may remove pads that should be provided between the plurality of via electrodes, thereby improving signal transmission characteristics.

In addition, the circuit board according to embodiments may include a core layer, a first insulating layer disposed on the core layer, and a second insulating layer disposed on the first insulating layer. In addition, the first insulating layer may be a thermosetting insulating layer, and the second insulating layer may be a photocurable insulating layer. That is, the circuit board according to embodiments includes the thermosetting insulating layer disposed between the core layer and the photocurable insulating layer. In addition, the thermosetting insulating layer disposed between the core layer and the photocurable insulating layer may function as a buffer layer for buffering stress applied to the circuit board. That is, the core layer improves rigidity of the circuit board, and the photocurable insulating layer enables miniaturization of the via electrode and/or circuit layer. In this case, the core layer may have a relatively low elastic modulus and/or coefficient of thermal expansion, and the photocurable insulating layer may have a relatively high elastic modulus and/or coefficient of thermal expansion. In addition, when the photocurable insulating layer is directly disposed on the core layer, the circuit board may be greatly warped in a specific direction due to a difference in elastic modulus and/or coefficient of thermal expansion between the core layer and the photocurable insulating layer, such that it may be difficult for the semiconductor device to be stably disposed on the circuit board. Accordingly, the thermosetting insulating layer having an elastic modulus and/or coefficient of thermal expansion greater than the elastic modulus and/or coefficient of thermal expansion of the core layer and having an elastic modulus and/or coefficient of thermal expansion smaller than the elastic modulus and/or coefficient of thermal expansion of the photocurable insulating layer may be disposed between the core layer and the photocurable insulating layer. Accordingly, by disposing the thermosetting insulating layer between the core layer and the photocurable insulating layer, it is possible to prevent the circuit board from being greatly warped in a specific direction, allow the semiconductor device to be stably disposed on the circuit board, and allow the semiconductor device to operate stably. Accordingly, products such as a server to which the circuit board and semiconductor package according to embodiments are applied may operate stably. In addition, adhesion between the core layer and the thermosetting insulating layer and adhesion between the thermosetting insulating layer and the photocurable insulating layer may be secured, thereby improving mechanical reliability and/or electrical reliability of the circuit board and the semiconductor package including the same.

### Description of Drawings

FIG. 1a is a cross-sectional view illustrating a circuit board according to a first embodiment.
FIG. 1b is an enlarged cross-sectional view illustrating a cavity provided in the second insulating layer of FIG. 1a.
FIG. 1c is a plan view illustrating the via electrode of FIG. 1a cut along line A-A'.
FIG. 2 is a plan view illustrating the via electrode of FIG. 1a according to a second embodiment cut along line A-A'.
FIG. 3a is a cross-sectional view illustrating a via electrode of a circuit board according to a third embodiment.
FIG. 3b is a plan view illustrating the via electrode of FIG. 3a cut along line B-B'.
FIG. 4a is a cross-sectional view illustrating a via electrode of a circuit board according to a fourth embodiment.
FIG. 4b is a view combining a plan view illustrating the via electrode of FIG. 4a according to the first embodiment cut along line C-C' and a plan view illustrating a lower pad cut along line D-D'.
FIG. 4c is a plan view illustrating the lower pad of FIG. 4a according to the second embodiment cut along line D-D'.
FIG. 5 is a cross-sectional view illustrating a modified example of the circuit board illustrated in FIG. 1a.
FIG. 6a is a cross-sectional view illustrating a via electrode of a circuit board according to a fifth embodiment.
FIG. 6b is a plan view illustrating the lower pad of FIG. 6a cut along line E-E'.
FIG. 7a is a cross-sectional view illustrating a via electrode of a circuit board according to a sixth embodiment.
FIG. 7b is a plan view illustrating the lower pad of FIG. 7a cut along line F-F'.
FIG. 8 is a cross-sectional view illustrating a circuit board according to a seventh embodiment.
FIG. 9 is a cross-sectional view illustrating a circuit board according to an eighth embodiment.
FIG. 10 is a cross-sectional view illustrating a circuit board according to a ninth embodiment.
FIG. 11a is a cross-sectional view illustrating a circuit board according to a tenth embodiment.
FIG. 11b is a cross-sectional view illustrating a circuit board according to an eleventh embodiment.
FIG. 11c is a cross-sectional view illustrating a circuit board according to a twelfth embodiment.
FIG. 11d is a cross-sectional view illustrating a circuit board according to a thirteenth embodiment.
FIG. 12 is a cross-sectional view illustrating a semiconductor package according to the first embodiment.
FIG. 13 is a cross-sectional view illustrating a semiconductor package according to the second embodiment.
FIG. 14 is a cross-sectional view illustrating a semiconductor package according to the third embodiment.
FIG. 15 is a cross-sectional view illustrating a semiconductor package according to the fourth embodiment.

### Modes of the Invention

Hereinafter, embodiments of the present disclosure will be described in detail with reference to the accompanying drawings.

However, the spirit and scope of the present disclosure is not limited to a part of the embodiments described, and may be implemented in various other forms, and within the spirit and scope of the present disclosure, one or more of the elements of the embodiments may be selectively combined and redisposed.

In addition, unless expressly otherwise defined and described, the terms used in the embodiments of the present disclosure (including technical and scientific terms) may be construed to have the same meaning as commonly understood by one of ordinary skill in the art to which the present disclosure belongs, and the terms such as those defined in commonly used dictionaries may be interpreted as having a meaning that is consistent with their meaning in the context of the relevant art.

In addition, the terms used in the embodiments of the present disclosure are for describing the embodiments and are not intended to limit the present disclosure. In this specification, the singular forms may also include the plural forms unless specifically stated in the phrase, and may include at least one of all combinations that may be combined in A, B, and C when described in "at least one (or more) of A (and), B, and C". In addition, in describing the elements of the embodiments of the present disclosure, the terms such as first, second, A, B, (a), and (b) may be used.

These terms are only used to distinguish the elements from other elements, and the terms are not limited to the essence, order, or order of the elements. In addition, when an element is described as being "connected", "coupled", or "contacted" to another element, it may include not only when the element is directly "connected" to, "coupled" to, or "contacted" to other elements, but also when the element is "connected", "coupled", or "contacted" by another element between the element and other elements.

In addition, when described as being formed or disposed "on (over)" or "under (below)" of each element, the "on (over)" or "under (below)" may include not only when two elements are directly connected to each other, but also when one or more other elements are formed or disposed between two elements. In addition, when expressed as "on (over)" or "under (below)", it may include not only the upper direction but also the lower direction based on one element.

Terms used in the present application are used only to describe specific embodiments and are not intended to limit the present invention. Singular expressions include plural expressions unless the context clearly indicates otherwise. In the present application, terms such as "include" or "have" are intended to designate the presence of features, numbers, steps, operations, components, parts, or combinations thereof described in the specification, and should be understood as not precluding the presence or addition of one or more other features, numbers, steps, operations, components, parts, or combinations thereof.

Unless otherwise defined, all terms used herein, including technical or scientific terms, have the same meanings as those generally understood by those skilled in the art to which the present invention pertains. Terms defined in commonly used dictionaries should be interpreted as having meanings consistent with their meanings in the context of the related art, and should not be interpreted in an ideal or excessively formal sense unless expressly defined in the present application.

Hereinafter, embodiments will be described in detail with reference to the accompanying drawings. Regardless of drawing reference numerals, the same or corresponding components will be assigned the same reference numerals, and repeated descriptions thereof will be omitted.

Prior to the description of embodiments, an electronic device (not illustrated) to which the semiconductor package according to embodiments is applied will be briefly described. The electronic device may be a smart phone, a personal digital assistant, a digital video camera, a digital still camera, a vehicle, a high-performance server, a network system, a computer, a monitor, a tablet, a laptop, a netbook, a television, a video game device, a smart watch, an automotive device, or the like. However, the present disclosure is not limited thereto, and any other electronic device processing data may also be used.

The electronic device includes a main board (not illustrated). The main board may be physically and/or electrically connected to various components. For example, the main board may be connected to the semiconductor package according to embodiments. In addition, the semiconductor package includes a circuit board, a semiconductor device, a bonding portion bonded to electrically connect the semiconductor device and the circuit board, a resin portion filling a space between the semiconductor device and the circuit board, and a molding portion entirely surrounding the semiconductor device.

The semiconductor device may include an active device and/or a passive device, and may have various functions. The active device may be in the form of an integrated circuit (IC) in which several hundreds to several millions or more transistors are integrated in one semiconductor device, and may be, for example, a logic chip or a memory chip. For example, the logic chip may be an application processor (AP) device including at least one among a central processing unit (CPU), a graphics processing unit (GPU), a digital signal processor, an encryption processor, a microprocessor, and a microcontroller, or may be an analog-to-digital converter, an application-specific IC (ASIC), or a set of devices including a specific combination of those listed above. The memory chip may be a stacked memory such as a high bandwidth memory (HBM). In addition, the memory chip may include memory chips such as volatile memory (for example, DRAM), non-volatile memory (for example, ROM), and flash memory.

The semiconductor package according to embodiments may be any one among a chip scale package (CSP), a flip chip-chip scale package (FC-CSP), a flip chip ball grid array (FC-BGA), a package on package (POP), and a system in package (SIP), but is not limited thereto.

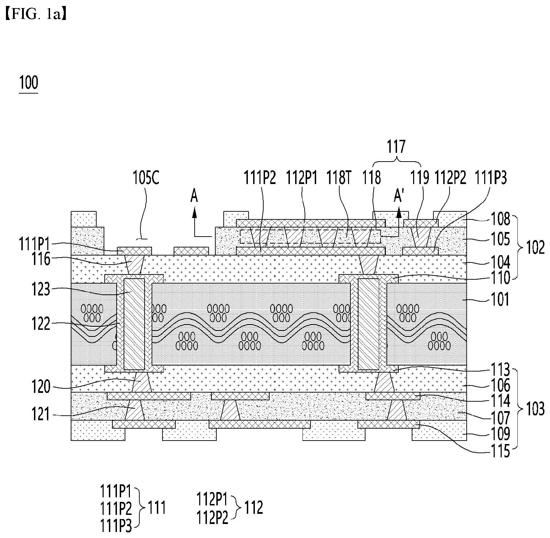

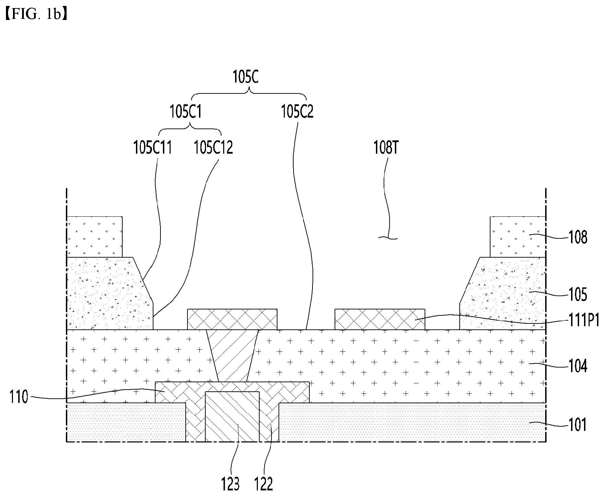

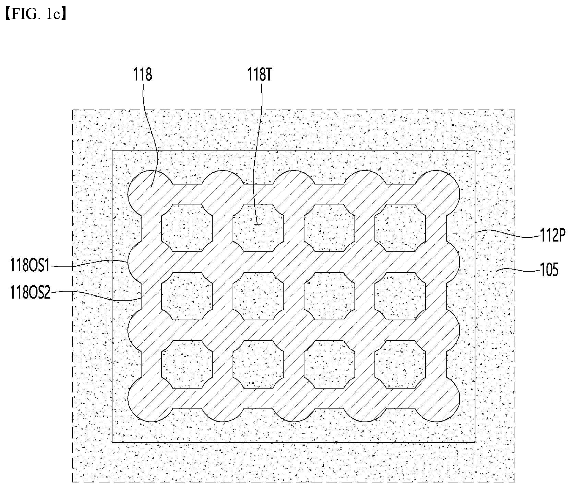

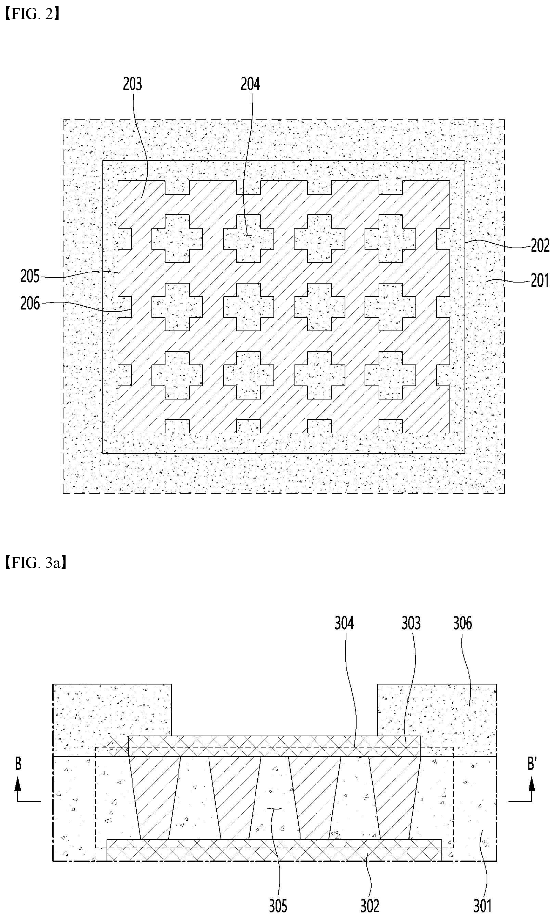

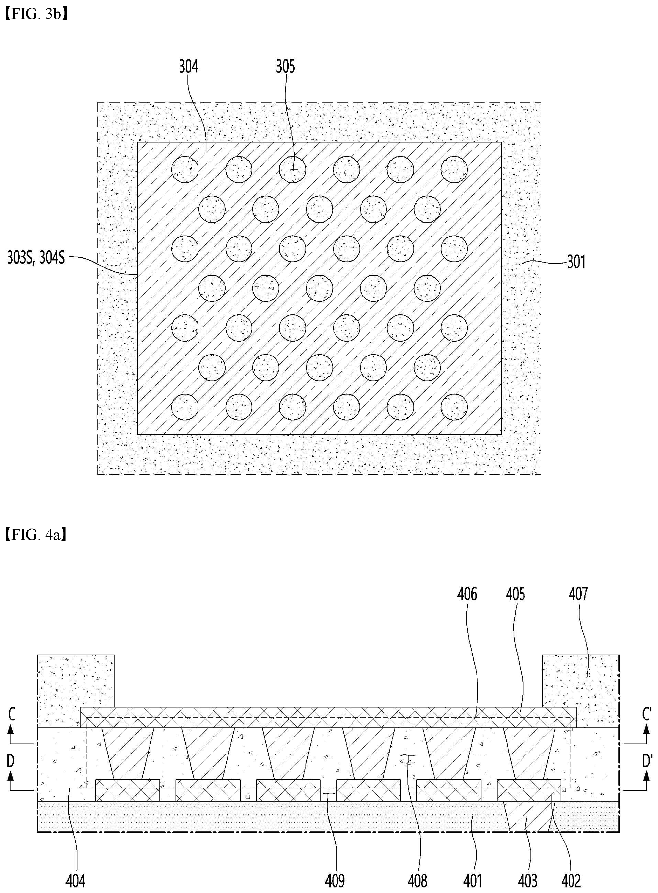

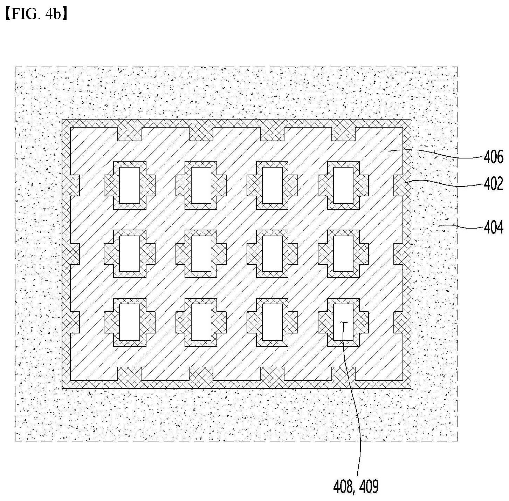

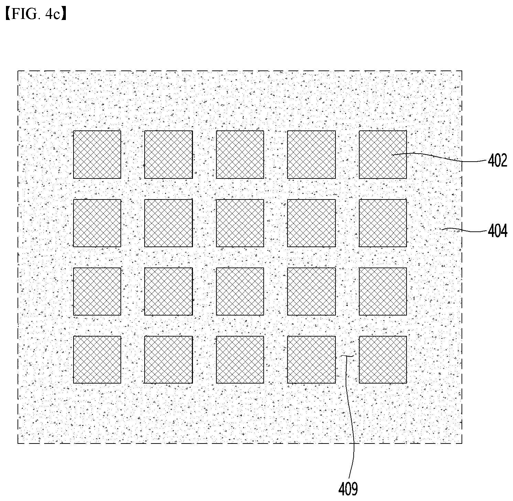

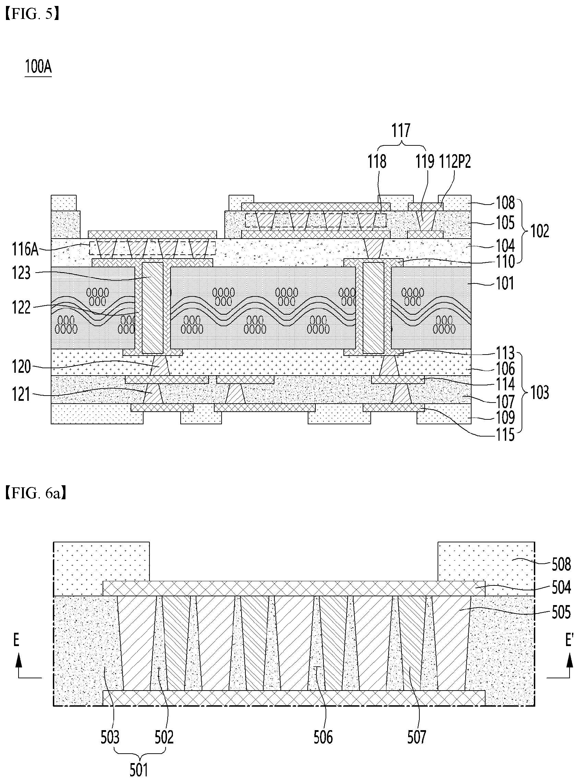

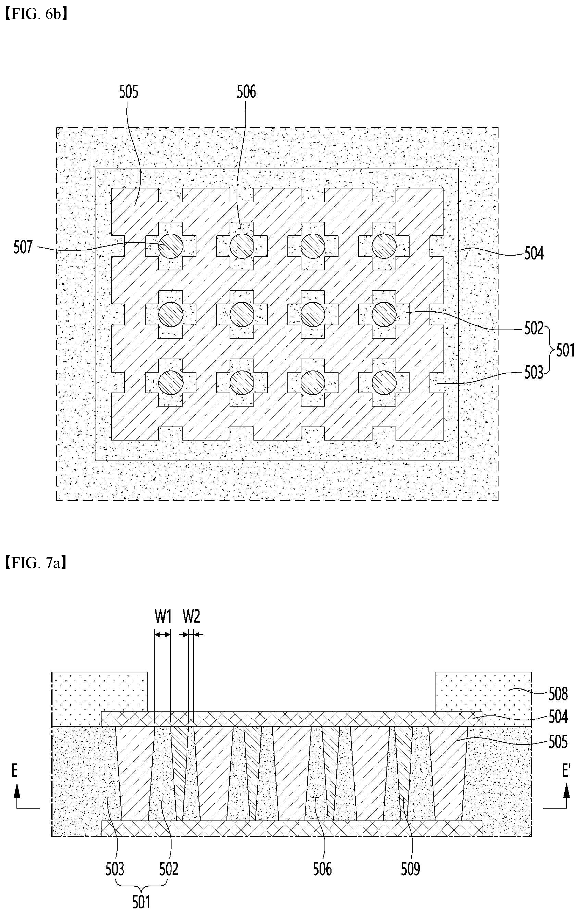

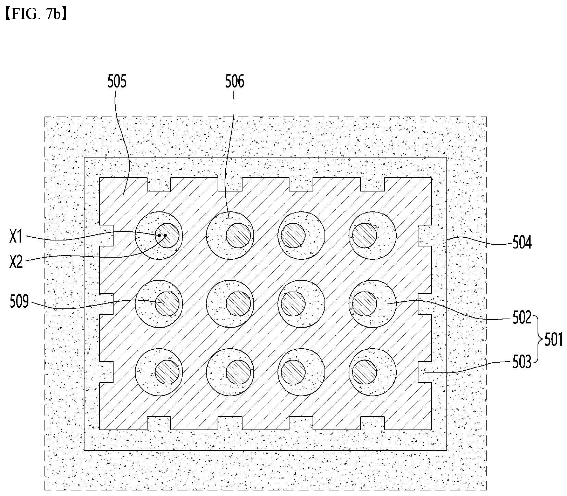

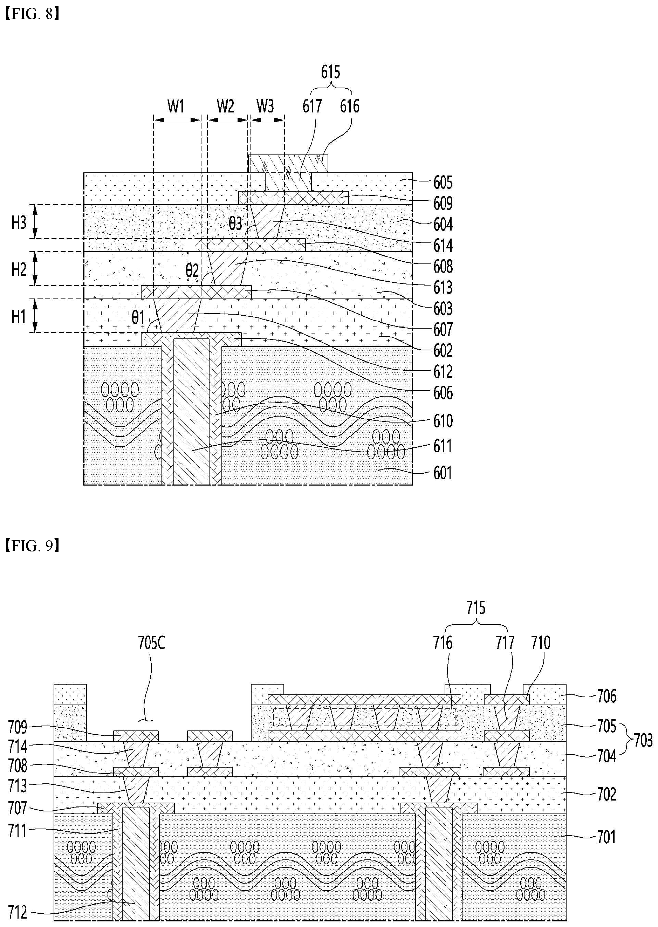

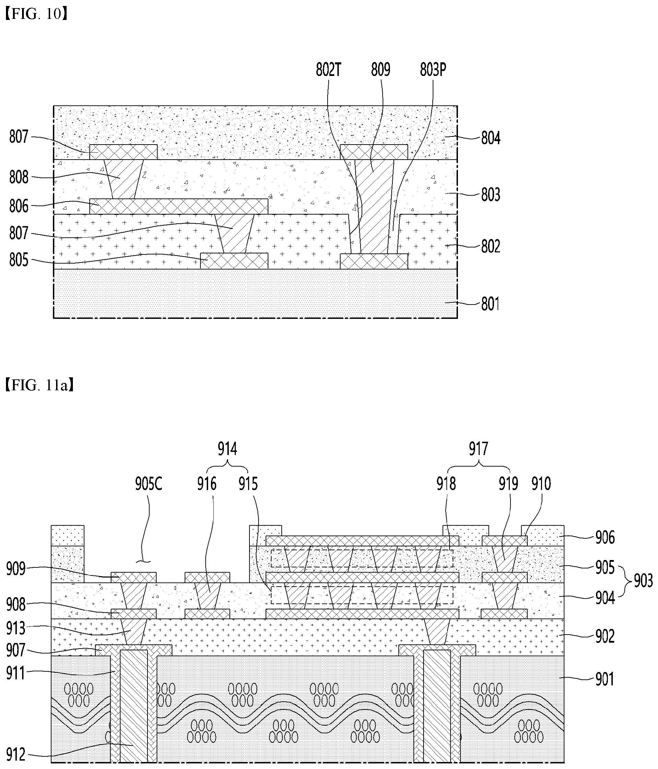

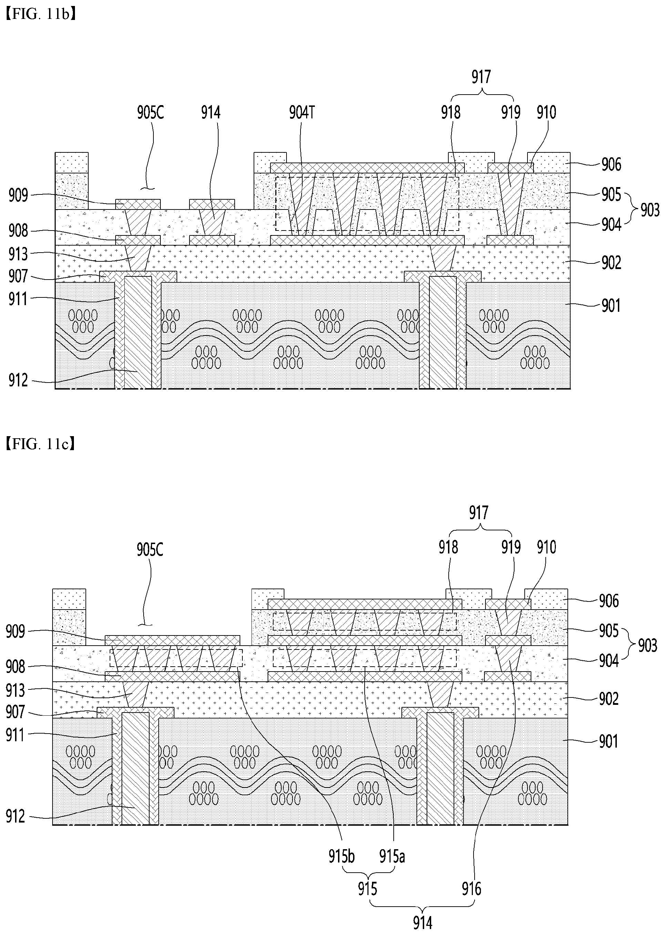

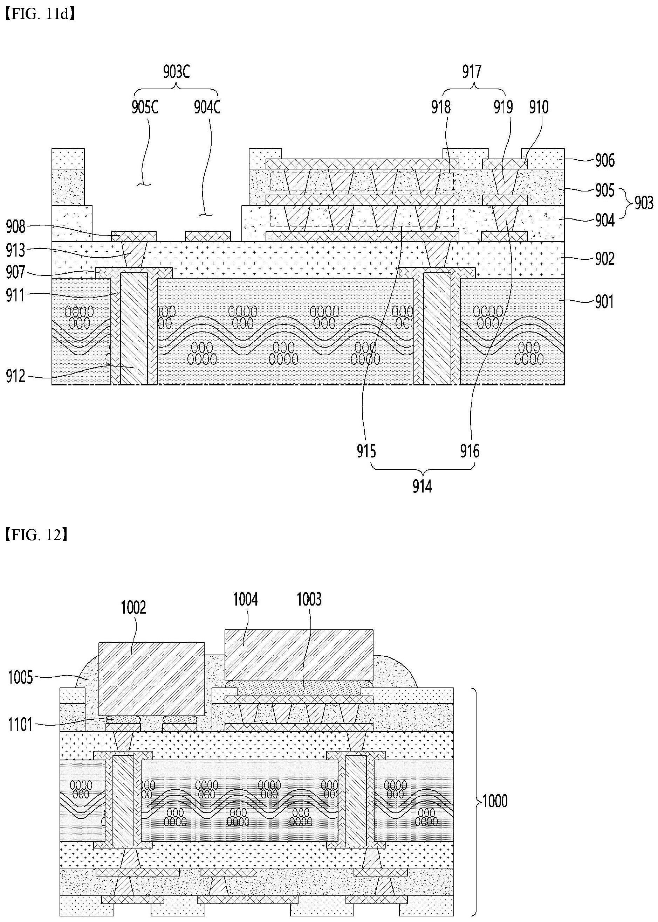

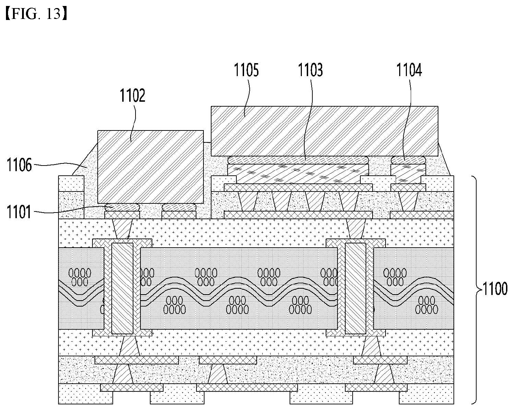

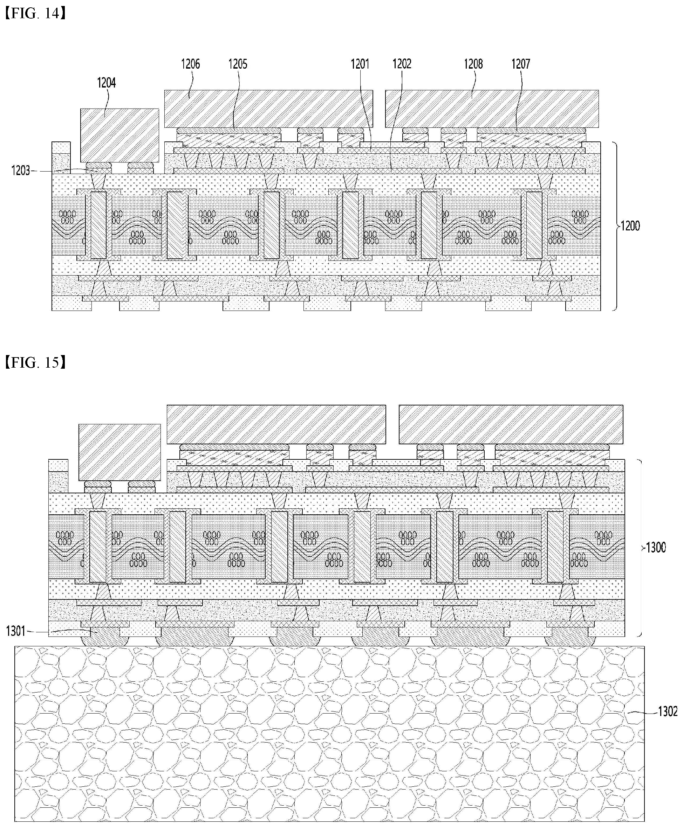

FIG. 1a is a cross-sectional view illustrating a circuit board according to a first embodiment, FIG. 1b is an enlarged cross-sectional view illustrating a cavity provided in the second insulating layer of FIG. 1a, FIG. 1c is a plan view illustrating the via electrode of FIG. 1a cut along line A-A', FIG. 2 is a plan view illustrating the via electrode of FIG. 1a according to a second embodiment cut along line A-A', FIG. 3a is a cross-sectional view illustrating a via electrode of a circuit board according to a third embodiment, FIG. 3b is a plan view illustrating the via electrode of FIG. 3a cut along line B-B', FIG. 4a is a cross-sectional view illustrating a via electrode of a circuit board according to a fourth embodiment, FIG. 4b is a view combining a plan view illustrating the via electrode of FIG. 4a according to the first embodiment cut along line C-C' and a plan view illustrating a lower pad cut along line D-D', FIG. 4c is a plan view illustrating the lower pad of FIG. 4a according to the second embodiment cut along line D-D', FIG. 5 is a cross-sectional view illustrating a modified example of the circuit board illustrated in FIG. 1a, FIG. 6a is a cross-sectional view illustrating a via electrode of a circuit board according to a fifth embodiment, FIG. 6b is a plan view illustrating the lower pad of FIG. 6a cut along line E-E', FIG. 7a is a cross-sectional view illustrating a via electrode of a circuit board according to a sixth embodiment, FIG. 7b is a plan view illustrating the lower pad of FIG. 7a cut along line F-F', FIG. 8 is a cross-sectional view illustrating a circuit board according to a seventh embodiment, FIG. 9 is a cross-sectional view illustrating a circuit board according to an eighth embodiment, FIG. 10 is a cross-sectional view illustrating a circuit board according to a ninth embodiment, FIG. 11a is a cross-sectional view illustrating a circuit board according to a tenth embodiment, FIG. 11b is a cross-sectional view illustrating a circuit board according to an eleventh embodiment, FIG. 11c is a cross-sectional view illustrating a circuit board according to a twelfth embodiment, FIG. 11d is a cross-sectional view illustrating a circuit board according to a thirteenth embodiment, FIG. 12 is a cross-sectional view illustrating a semiconductor package according to the first embodiment, FIG. 13 is a cross-sectional view illustrating a semiconductor package according to the second embodiment, FIG. 14 is a cross-sectional view illustrating a semiconductor package according to the third embodiment, and FIG. 15 is a cross-sectional view illustrating a semiconductor package according to the fourth embodiment.

Hereinafter, the circuit board according to embodiments and the semiconductor package including the same will be described in detail with reference to FIGS. 1a to 15.

Referring to FIG. 1a, the circuit board 100 includes a core layer 101, a first buildup layer 102 disposed on one surface of the core layer 101, and a second buildup layer 103 disposed on another surface of the core layer 101. Here, being disposed on one surface and another surface should not be understood only as a configuration directly contacting the one surface and the other surface, but should also be understood as including a configuration in which another component is present between the one surface and the first buildup layer 102 and between another surface and the second buildup layer 103.

The core layer 101 is formed of a resin such as an epoxy resin or BT (bismaleimide triazine) and a reinforcing material such as glass fiber, and functions to improve rigidity of the circuit board 100.

As the number of terminals of a semiconductor device disposed on a recent circuit board 100 increases, wiring becomes complicated, and accordingly, thicknesses of the first and second buildup layers 102 and 103 tend to increase. Accordingly, the core layer 101 of the present embodiment may have a thickness of 200 µm to 1200 µm in order to improve the overall rigidity of the circuit board 100 and prevent excessive signal loss. A via hole penetrating one surface and another surface may be formed in the core layer 101. The via hole of the core layer 101 may be formed using a mechanical drilling process, a CO₂ laser, or the like. When the via hole of the core layer 101 is formed using a mechanical drill, an inclination of an inner wall of the via hole may be perpendicular to one surface and/or another surface of the core layer 101. When the via hole of the core layer 101 is formed using a CO₂ laser, the inner wall of the via hole may include a plurality of concave portions and/or convex portions alternately stacked in a vertical direction. Here, the concave portion may refer to a region concave in a direction away from a center in a horizontal direction of the via hole provided in the core layer 101, and the convex portion may refer to a region protruding and/or convex toward the center in the horizontal direction of the via hole provided in the core layer 101. In the case of the via hole formed using the mechanical drilling process, a path through which an electrical signal is transmitted is shortened, which may be advantageous in electrical characteristics, and a yield of forming a via hole in the thick core layer 101 may be high, but process cost may increase. In addition, when the concave portions and the convex portions are formed on the inner wall of the via hole using a CO₂ laser, the thickness of the core via electrode 122 provided on the inner wall of the via hole in a subsequent process may be increased, thereby having an advantage of lowering impedance and an advantage of lowering process cost. Accordingly, a processing method of the via hole provided in the core layer 101 may be freely and selectively used depending on an application field of the semiconductor package.

A core via electrode 122 may be disposed in a via hole of the core layer 101. The core via electrode 122 functions to electrically connect the first buildup layer 102 and the second buildup layer 103. Accordingly, it is preferable that the core via electrode 122 densely fill the via hole for resistance or heat dissipation. However, when the thickness of the core layer 101 becomes thick as described above, it may be difficult for the core via electrode 122 to densely fill the via hole. For example, when the via hole provided in the thick core layer 101 as described above is to be filled according to a plating process, a void may occur in the core via electrode 122. The void expands due to heat generated while the semiconductor package operates, thereby becoming a factor that degrades mechanical reliability of the circuit board. Accordingly, the core via electrode 122 having a predetermined thickness is disposed on the inner wall of the via hole of the core layer 101. The thickness of the core via electrode 122 refers not to a thickness in a vertical direction in which the first buildup layer 102, the core layer 101, and the second buildup layer 103 are stacked, but to a thickness in a horizontal direction perpendicular thereto. The core via electrode 122 may be disposed to have a thickness of 5 µm to 20 µm in order to prevent a voltage drop caused as the thickness of the core layer 101 increases and to prevent occurrence of a void. It is difficult to densely fill the inside of the core via electrode 122 with metal by a process such as plating, and thus an empty space is formed. The empty space may cause a problem in that it is difficult to flatly dispose the first buildup layer 102 when the first buildup layer 102 is stacked.

Accordingly, an insulating member 123 may be disposed inside the core via electrode 122, and thus flatness of the core layer 101 may be secured. An upper surface of the insulating member 123 may be on a same plane as an upper surface of the core layer 101, or may be disposed closer to the first buildup layer 102 than an upper surface of the core layer 101 along the vertical direction. A lower surface of the insulating member 123 may be on a same plane as a lower surface of the core layer 101, or may be disposed closer to the second buildup layer 103 than the lower surface of the core layer 101 along the vertical direction. This may be freely designed in order to resolve flatness when the first buildup layer 102 and the second buildup layer 103 are stacked, or to secure flatness of a first circuit layer 110 and/or a fourth circuit layer 113, which will be described below.

The first buildup layer 102 is disposed on one surface of the core layer 101. The first buildup layer 102 includes a plurality of insulating layers 104 and 105, a plurality of circuit layers 110, 111, and 112, a plurality of via electrodes 116 and 117, and a first protective layer 108.

The plurality of circuit layers 110, 111, and 112 of the first buildup layer 102 may include a first circuit layer 110 disposed closest to the core layer 101 along the vertical direction, a second circuit layer 111 farther from the core layer 101 than the first circuit layer 110 along the vertical direction, and a third circuit layer 112 farther from the core layer 101 than the second circuit layer 111 along the vertical direction.

The first to third circuit layers 110, 111, and 112 may function to be electrically connected to a semiconductor device disposed on the circuit board 100. Each of the first to third circuit layers 110, 111, and 112 may be freely designed in consideration of impedance. Each of the first to third circuit layers 110, 111, and 112 may include a trace for transmitting a signal and/or power, and a pad for connecting the trace of each of the first to third circuit layers 110, 111, and 112 to another component. For example, referring to FIG. 1a, the first circuit layer 110 and the second circuit layer 111 may be connected by the first via electrode 116. In this case, in order for the first via electrode 116 and the trace of the second circuit layer 111 to be connected, the second circuit layer 111 may include a plurality of pads connected to the first via electrode 116, and the plurality of pads of the second circuit layer 111 may include a first pad 111P1 overlapping a cavity 105C provided in the second insulating layer 105 in the vertical direction, which will be described below. In addition, the second circuit layer 111 may include pads connected to the second via electrode 117. The second via electrode 117 may include a second-first via electrode 118 and a second-second via electrode 119 according to size, function, and/or arrangement position. In addition, the second circuit layer 111 may include a second pad 111P2 connected to a pad of the third circuit layer 112 through the second-first via electrode 118 or connecting the trace of the second circuit layer 111 and the second-first via electrode 118. In addition, the second circuit layer 111 may include a third pad 111P3 connected to a pad of the third circuit layer 112 through the second-second via electrode 119 or connecting the trace of the second circuit layer 111 and the second-second via electrode 119. In addition, the third circuit layer 112 may include a fourth pad 112P1 connected to the second circuit layer 111 through the second-first via electrode 118 or connecting the second-first via electrode 118 and the trace of the third circuit layer 112. In addition, the third circuit layer 112 may include a fifth pad 112P2 connected to the second circuit layer 111 through the second-second via electrode 119 or connecting the second-second via electrode 119 and the trace of the third circuit layer 112. That is, although FIG. 1a illustrates only pads of the first to third circuit layers 110, 111, and 112, each of the first to third circuit layers 110, 111, and 112 may further include a trace connecting the plurality of pads to each other.

In addition, via electrodes 116 and 117 may be disposed to connect each of the first to third circuit layers 110, 111, and 112. For example, the first via electrode 116 is disposed between the first circuit layer 110 and the second circuit layer 111, and the second via electrode 117 is disposed between the second circuit layer 111 and the third circuit layer 112, thereby electrically connecting the first to third circuit layers 110, 111, and 112. The first and second via electrodes 116 and 117 may be formed simultaneously in a process of disposing the second and third circuit layers 111 and 112. For example, in a process of disposing the second circuit layer 111 on the first circuit layer 110, a through hole may be formed in the first insulating layer 104, which will be described below, to expose a portion of the first circuit layer 110, and accordingly, the second circuit layer 111 may be disposed together with the first via electrode 116 filling the through hole of the first insulating layer 104. Accordingly, the first via electrode 116 may be classified as a protrusion of the second circuit layer 111. Similarly, the second via electrode 117 may be classified as a protrusion of the third circuit layer 112 and may be connected to the second circuit layer 111 disposed under the third circuit layer 112. The second via electrode 117 may be divided into a second-first via electrode 118 and a second-second via electrode 119 according to size and/or function and/or arrangement position. A size of the second-first via electrode 118 may be larger than a size of the second-second via electrode 119. Here, the size may refer to a width and/or area of an upper surface and a width and/or area of a lower surface of each of the second-first via electrode 118 and the second-second via electrode 119. The width and/or area of the upper surface and/or lower surface of the second-first via electrode 118 may be larger than the width and/or area of the upper surface and/or lower surface of the second-second via electrode 119. For example, the second-first via electrode 118 may function to transfer heat, and the second-second via electrode 119 may function to transfer a signal and/or power, but the embodiment is not limited thereto. Here, the second-first via electrode 118 and the second-second via electrode 119 may be classified according to function as described above, or may be classified according to configuration. For example, the second-first via electrode 118 may have a configuration including a plurality of through holes penetrating upper and lower surfaces of the via electrode, and the second-second via electrode 119 may have a configuration in which a via electrode connected to one pad does not include a through hole. Detailed structures of the second-first via electrode 118 and the second-second via electrode 119 will be described below.

In addition, since the first to third circuit layers 110, 111, and 112 are sequentially stacked from the upper surface of the core layer 101 along the vertical direction, inclination directions of the first via electrode 116 and the second via electrode 117 may be the same as each other. For example, each of the first via electrode 116 and the second via electrode 117 may have an inclination in which a width in the horizontal direction gradually increases in a direction from the core layer 101 toward the first protective layer 108.

The first circuit layer 110 may contact one surface of the core layer 101. In this case, a portion of the first circuit layer 110 may be disposed to cover the above-described insulating member 123. A portion of the first circuit layer 110 covering the insulating member 123 may have a thickness smaller than a thickness of remaining portions that do not overlap the insulating member 123 in the vertical direction. Here, the thickness of the first circuit layer 110 refers to a thickness along the vertical direction. When the first circuit layer 110 is designed, the first circuit layer 110 may or may not cover the insulating member 123 depending on a degree of freedom of wiring, and accordingly, freedom of wiring connection may be increased. When the first circuit layer 110 does not cover the insulating member 123, the insulating member 123 may directly contact the first insulating layer 104. Compared to a case in which the insulating member 123 and the first insulating layer 104 directly contact each other, bonding force may be better and heat dissipation may be advantageous when the first circuit layer 110 and the first insulating layer 104 contact each other. However, in order to reduce process cost, the first circuit layer 110 may be disposed not to cover the insulating member 123.

The plurality of insulating layers 104 and 105 of the first buildup layer 102 may include a first insulating layer 104 disposed closest to the core layer 101 along the vertical direction, and a second insulating layer 105 farther from the core layer 101 than the first insulating layer 104 along the vertical direction.

The first insulating layer 104 and the second insulating layer 105 are disposed for insulation in the vertical direction between the above-described first to third circuit layers 110, 111, and 112. In one embodiment, a thermosetting insulating material in which an inorganic filler is contained in a thermosetting resin may be used as the first insulating layer 104, and for example, Ajinomoto Build-up Film (ABF) manufactured by Ajinomoto may be used. In another embodiment, a thermosetting insulating material in which an inorganic filler and a reinforcing member (for example, glass fiber) are contained in a thermosetting resin may be used as the first insulating layer 104, and for example, prepreg (PPG) may be used. Although FIG. 1a illustrates that the first insulating layer 104 is implemented as one layer, the embodiment is not limited thereto, and the first insulating layer 104 may be provided as two or more layers between the core layer 101 and the second insulating layer 105. In addition, when the first insulating layer 104 is provided as two or more layers, both of the two first insulating layers 104 may be implemented as a thermosetting insulating material not including a reinforcing member, or may be implemented as a thermosetting insulating material not including a reinforcing member, or may be implemented by stacking, along the vertical direction, a thermosetting insulating material including a reinforcing member and a thermosetting insulating material not including a reinforcing member.

The second insulating layer 105 may be disposed on the first insulating layer 104. A photocurable insulating material in which an inorganic filler is contained in a photocurable insulating resin may be used as the second insulating layer 105, and for example, a photo imageable dielectric (PID) may be used as the second insulating layer 105. The second insulating layer 105 may include an epoxy resin, a photoinitiator, a silicon-based filler (Si filler), a curing agent, and the like. The second insulating layer 105 may be formed by stacking a photocurable resin film or by applying a photocurable resin paste or liquid. In this case, in one example, the photocurable insulating material constituting the second insulating layer 105 may include at least one selected from photocurable polyhydroxystyrene (PHS), photocurable polybenzoxazole (PBO), photocurable polyimide (PI), photocurable benzocyclobutene (BCB), photocurable polysiloxane, photocurable epoxy, and Novolac resin. Unlike the first insulating layer 104, the second insulating layer 105 may have a through hole formed through exposure and development processes, and accordingly, it is possible to miniaturize a width in the horizontal direction of the via electrode and, furthermore, to miniaturize a width and/or pitch of the circuit layer connected to the via electrode. Furthermore, the second insulating layer 105 is an insulating layer located closest to a semiconductor device disposed on the circuit board among a plurality of insulating layers stacked on the circuit board 100 along the vertical direction, and accordingly, miniaturization of the second via electrode 117 and/or the third circuit layer 112 provided in the second insulating layer 105 is required. For example, the third circuit layer 112 may include a pad connected to the semiconductor device, and miniaturization of the pad connected to the semiconductor device is required. Accordingly, the second insulating layer 105 is disposed closest to the semiconductor device to enable miniaturization of the second via electrode 117 and/or the third circuit layer 112.

The first insulating layer 104 provided between the core layer 101 and the second insulating layer 105 may function as a buffer layer that buffers stress applied to the circuit board 100. That is, the core layer 101 allows rigidity of the circuit board 100 to be improved, and the second insulating layer 105 enables miniaturization of the via electrode and/or circuit layer. In this case, the core layer 101 may have a relatively low elastic modulus and/or coefficient of thermal expansion, and the second insulating layer 105 may have a relatively high elastic modulus and/or coefficient of thermal expansion. In addition, when the second insulating layer 105 is directly disposed on the core layer 101, the circuit board 100 may be greatly warped in a specific direction due to a difference in elastic modulus and/or coefficient of thermal expansion between the core layer 101 and the second insulating layer 105, such that it may be difficult for the semiconductor device to be stably disposed on the circuit board 100. In addition, components of the circuit board 100 may expand and/or contract due to heat generated in a manufacturing process and/or an operating environment. When the second insulating layer 105 is directly disposed on the core layer 101, stress may be concentrated at an interface between the core layer 101 and the second insulating layer 105 due to the difference in elastic modulus and/or coefficient of thermal expansion, thereby causing a mechanical reliability problem such as delamination.

The first insulating layer 104 may be disposed between the core layer 101 and the second insulating layer 105 to function as a buffer layer that buffers a difference between the elastic modulus and/or coefficient of thermal expansion of the core layer 101 and the elastic modulus and/or coefficient of thermal expansion of the second insulating layer 105. Specifically, the elastic modulus and/or coefficient of thermal expansion of the first insulating layer 104 may have a value between the elastic modulus and/or coefficient of thermal expansion of the core layer 101 and the elastic modulus and/or coefficient of thermal expansion of the second insulating layer 105. By disposing the first insulating layer 104 between the core layer 101 and the second insulating layer 105, it is possible to prevent the circuit board 100 from being greatly warped in a specific direction, allow the semiconductor device to be stably disposed on the circuit board 100, and allow the semiconductor device to operate stably. Accordingly, products such as a server to which the circuit board and semiconductor package according to embodiments are applied may operate stably. In addition, adhesion between the core layer 101 and the first insulating layer 104 and adhesion between the first insulating layer 104 and the second insulating layer 105 may be secured, thereby improving mechanical reliability and/or electrical reliability of the circuit board and the semiconductor package including the same.

In addition, recently, as functions provided by semiconductor devices increase and performance of semiconductor devices improves, the number of I/O terminals provided in semiconductor devices is also increasing. Accordingly, more heat may be generated from the semiconductor device, and higher heat dissipation characteristics of the circuit board on which the semiconductor device is disposed are required. Accordingly, the circuit board includes a via electrode having a heat dissipation function, and the above-described via electrode may be provided by filling a via hole formed through a laser process with a conductive material. However, there are limitations in designing a via hole that can be formed in the insulating layer according to laser process capability, a large amount of time and/or cost may be required to form the via hole, or product yield or heat dissipation characteristics may be degraded. Accordingly, the embodiment includes the second insulating layer 105 and forms a via hole for disposing the via electrode in the second insulating layer 105. In this case, the via hole is formed in the second insulating layer 105 through exposure and development processes, and accordingly, the via hole may be formed with a design capable of implementing optimal heat dissipation performance according to an arrangement position of the semiconductor device disposed on the circuit board, thereby improving heat dissipation characteristics of the circuit board and/or semiconductor package. As a result, the semiconductor device may operate more stably.

In addition, the second insulating layer 105 may include the cavity 105C. The cavity 105C may penetrate an upper surface and a lower surface of the second insulating layer 105. The cavity 105C may be formed together with a through hole in a process of forming the through hole corresponding to the second via electrode 117 in the second insulating layer 105. In addition, the cavity 105C may be formed by exposing and developing the second insulating layer 105, and therefore, a metal member such as a laser stopper, which should be provided on a bottom surface of the cavity in order to form the cavity 105C through a laser process, may be removed. In this case, the metal member is provided in a closed-loop shape along a circumferential direction of the bottom surface of the cavity 105C. Accordingly, when the metal member is provided, it was difficult to dispose a trace directly connecting the first pad 111P1 overlapping the cavity 105C in the vertical direction and the second pad 111P2 and/or the third pad 111P3 not overlapping the cavity 105C in the vertical direction due to an electrical short-circuit problem with the above-described metal member. In contrast, it is possible to remove the metal member by forming the cavity 105C in the second insulating layer 105, and thus, it is possible to dispose a trace directly connecting the first pad 111P1 and the second pad 111P2 and/or the third pad 111P3. Accordingly, circuit integration may be improved, and signal transmission loss may be minimized by reducing a signal transmission distance between the plurality of pads.

The cavity 105C provides a space in which a connection member and/or a semiconductor device is mounted. Recently, as the number of signals to be processed by a semiconductor device increases, the size of the semiconductor device tends to increase. Such increase in area of the semiconductor device causes a problem of lowering a yield of the semiconductor device. Accordingly, there is a trend of dividing a pattern size or functional portions of the semiconductor device, disposing chiplets on the circuit board 100, and embedding a connection member having a function of electrically connecting the chiplets in the circuit board 100. In addition, the connection member may be disposed in the cavity 105C. However, embodiments are not limited thereto, and the connection member disposed in the cavity 105C may also connect a semiconductor device and a semiconductor device having another function, such as memory. In addition, a semiconductor device may be disposed in the cavity 105C. Since the connection member and/or the semiconductor device may be disposed in the cavity 105C provided in the second insulating layer 105, a thickness of the circuit board 100 in the vertical direction may be reduced by a depth of the cavity 105C compared to a case in which the connection member and/or the semiconductor device is disposed on the circuit board 100. In addition, a plurality of connection members and/or semiconductor devices may be disposed on the circuit board 100. In this case, among the plurality of connection members and/or semiconductor devices, a connection member and/or semiconductor device having a relatively large thickness in the vertical direction may be disposed in the cavity 105C provided in the second insulating layer 105, thereby reducing the thickness of the circuit board 100 in the vertical direction.

According to the embodiment of FIG. 1b, the cavity 105C provided in the second insulating layer 105 may include a sidewall 105C1 and a bottom surface 105. The cavity 105C is provided to penetrate the second insulating layer 105, and accordingly, the bottom surface 105 of the cavity 105C may be formed as an upper surface of the first insulating layer 104. The sidewall 105C1 of the cavity 105C may be provided with an inclination such that a width in a horizontal direction changes from the upper surface of the second insulating layer 105 toward the lower surface of the second insulating layer 105. The sidewall 105C1 of the cavity 105C may include a first sidewall 105C11 connected to the upper surface of the second insulating layer 105 and a second sidewall 105C12 provided between the first sidewall 105C11 and the lower surface of the second insulating layer 105. The first sidewall 105C11 may be inclined such that the width in the horizontal direction of the cavity 105C gradually decreases along a direction from the upper surface of the second insulating layer 105 toward the lower surface of the second insulating layer 105. The second sidewall 105C12 may be connected to the first sidewall 105C11 and may have an inclination angle different from an inclination angle of the first sidewall 105C11. The second sidewall 105C12 may have an inclination angle at which there is substantially no change in the width in the horizontal direction of the cavity 105C along a direction from the upper surface of the second insulating layer 105 toward the lower surface of the second insulating layer 105. The inclination angle of the second sidewall 105C12 may be closer to 90° than the inclination angle of the first sidewall 105C11. In addition, the second sidewall 105C12 may be provided closer to the first pad 111P1 overlapping the cavity 105C in the vertical direction than the first sidewall 105C11. Accordingly, in a process of disposing a connection member and/or a semiconductor device in the cavity 105C, the connection member and/or the semiconductor device may be disposed at an accurate position, and the connection member and/or the semiconductor device may be stably coupled onto the first pad 111P1. When the positions of the first sidewall 105C11 and the second sidewall 105C12 are changed with each other, the semiconductor device may contact the first sidewall 105C11 having a relatively gentle inclination angle in a process of disposing the connection member and/or the semiconductor device, and thus, the semiconductor device may not be stably disposed. In addition, when the width of the cavity 105C is increased in order to solve this, the third circuit layer 112 cannot be disposed in a region overlapping the cavity 105C in the vertical direction, and thus circuit integration may be reduced. Accordingly, embodiments may allow the connection member and/or the semiconductor device to be disposed at an accurate position without increasing the width of the cavity 105C.

The first protective layer 108 may protect the third circuit layer 118 from external moisture or contaminants. In addition, when the semiconductor device is disposed on the circuit board 100 with a material such as solder, the first protective layer 108 functions to prevent a short circuit between adjacent solders due to low wettability with solder. A photocurable insulating material may be used as the first protective layer 108, and for example, a solder resist may be used. Referring to FIG. 1b, the first protective layer 108 may include a through hole 108T overlapping the cavity 105C in the vertical direction. The through hole 108T may have a width in a horizontal direction different from a width in a horizontal direction of the cavity 105C. For example, the width in the horizontal direction of the through hole 108T of the first protective layer 108 may be greater than the width in the horizontal direction of the cavity 105C at the upper surface of the second insulating layer 105. For example, a sidewall of the through hole 108T of the first protective layer 108 may have a step with the first sidewall 105C11 and the second sidewall 105C12 of the cavity 105C. Accordingly, in a process of filling the cavity 105C with a molding member, adhesion between the molding member and the second insulating layer 105 and the first protective layer 108 may be improved.

The second buildup layer 103 is disposed on another surface of the core layer 101. The second buildup layer 103 includes a plurality of insulating layers 106 and 107, a plurality of circuit layers 113, 114, and 115, and a second protective layer 109.

The plurality of circuit layers 113, 114, and 115 of the second buildup layer 103 may include a fourth circuit layer 113 disposed closest to the core layer 101 along the vertical direction, a fifth circuit layer 114 farther from the core layer 101 than the fourth circuit layer 113 along the vertical direction, and a sixth circuit layer 115 farther from the core layer 101 than the fifth circuit layer 114 along the vertical direction.

The fourth to sixth circuit layers 113, 114, and 115 may function to be electrically connected to a semiconductor package substrate coupled to the circuit board 100 and/or a main board of an electronic device. Each of the fourth to sixth circuit layers 113, 114, and 115 may be freely designed in consideration of impedance. Each of the fourth to sixth circuit layers 113, 114, and 115 may include a trace for transmitting a signal and/or power, and a pad for connecting the trace of each of the fourth to sixth circuit layers 113, 114, and 115 to another component.

In addition, via electrodes 120 and 121 may be disposed to connect each of the fourth to sixth circuit layers 113, 114, and 115. For example, the third via electrode 120 is disposed between the fourth circuit layer 113 and the fifth circuit layer 114, and the fourth via electrode 121 is disposed between the fifth circuit layer 114 and the sixth circuit layer 115, thereby electrically connecting the fourth to sixth circuit layers 113, 114, and 115. The third and fourth via electrodes 120 and 121 may be formed simultaneously in a process of disposing the fifth and sixth circuit layers 114 and 115. For example, in a process of disposing the fifth circuit layer 114 under the fourth circuit layer 113, a through hole may be formed in the first insulating layer 106 of the second buildup layer 103, which will be described below, to expose a portion of the fourth circuit layer 113, and thus, the fifth circuit layer 114 may be disposed together with the third via electrode 120 filling the through hole of the first insulating layer 106. Accordingly, the third via electrode 120 may be classified as a protrusion of the fifth circuit layer 114. Similarly, the fourth via electrode 121 may be classified as a protrusion of the sixth circuit layer 115 and may be connected to the fifth circuit layer 114 disposed on the sixth circuit layer 115.

In addition, since the fourth to sixth circuit layers 113, 114, and 115 are sequentially stacked from the lower surface of the core layer 101 along the vertical direction, inclination directions of the third via electrode 120 and the fourth via electrode 121 may be the same as each other. For example, each of the third via electrode 120 and the fourth via electrode 121 may have an inclination in which a width in the horizontal direction gradually increases in a direction from the core layer 101 toward the second protective layer 109.

The fourth circuit layer 113 may contact one surface of the core layer 101. In this case, a portion of the fourth circuit layer 113 may be disposed to cover the above-described insulating member 123. A portion of the fourth circuit layer 113 covering the insulating member 123 may have a thickness smaller than a thickness of remaining portions that do not overlap the insulating member 123 in the vertical direction. Here, the thickness of the fourth circuit layer 113 refers to a thickness along the vertical direction. When the fourth circuit layer 113 is designed, the fourth circuit layer 113 may or may not cover the insulating member 123 depending on a degree of freedom of wiring, and accordingly, freedom of wiring connection may be increased. When the fourth circuit layer 113 does not cover the insulating member 123, the insulating member 123 may directly contact the first insulating layer 106. Compared to a case in which the insulating member 123 and the first insulating layer 106 directly contact each other, bonding force may be better and heat dissipation may be advantageous when the fourth circuit layer 113 and the first insulating layer 106 contact each other. However, in order to reduce process cost, the fourth circuit layer 113 may be disposed not to cover the insulating member 123.

The plurality of insulating layers 106 and 107 of the second buildup layer 103 may include a third insulating layer 106 disposed closest to the core layer 101 along the vertical direction, and a fourth insulating layer 107 farther from the core layer 101 than the third insulating layer 106 along the vertical direction.

The third insulating layer 106 and the fourth insulating layer 107 of the second buildup layer 103 are disposed for insulation in the vertical direction between the above-described fourth to sixth circuit layers 113, 114, and 115. In one embodiment, a thermosetting insulating material in which an inorganic filler is contained in a thermosetting resin may be used as the third insulating layer 106, and for example, Ajinomoto Build-up Film (ABF) manufactured by Ajinomoto may be used. In another embodiment, a thermosetting insulating material in which an inorganic filler and a reinforcing member (for example, glass fiber) are contained in a thermosetting resin may be used as the third insulating layer 104, and for example, prepreg (PPG) may be used. Although FIG. 1a illustrates that the third insulating layer 106 is implemented as one layer, the embodiment is not limited thereto, and the third insulating layer 106 may be provided as two or more layers between the core layer 101 and the fourth insulating layer 107 of the second buildup layer 103. In addition, when the third insulating layer 106 is provided as two or more layers, both of the two third insulating layers 106 may be implemented as a thermosetting insulating material not including a reinforcing member, or may be implemented as a thermosetting insulating material not including a reinforcing member, or may be implemented by stacking, along the vertical direction, a thermosetting insulating material including a reinforcing member and a thermosetting insulating material not including a reinforcing member. The fourth insulating layer 107 of the second buildup layer 103 may be disposed on the lower surface of the third insulating layer 106 of the second buildup layer 103. A photocurable insulating material in which an inorganic filler is contained in a photocurable insulating resin may be used as the fourth insulating layer 107, and for example, a photo imageable dielectric (PID) may be used as the photocurable insulating layer 107. The fourth insulating layer 107 may include an epoxy resin, a photoinitiator, a silicon-based filler (Si filler), a curing agent, and the like. The fourth insulating layer 105 may be formed by stacking a photocurable resin film or by applying a photocurable resin paste or liquid. In this case, in one example, the photocurable insulating material constituting the fourth insulating layer 105 may include at least one selected from photocurable polyhydroxystyrene (PHS), photocurable polybenzoxazole (PBO), photocurable polyimide (PI), photocurable benzocyclobutene (BCB), photocurable polysiloxane, photocurable epoxy, and Novolac resin. The plurality of insulating layers 106 and 107 of the second buildup layer 103 may have a symmetrical structure with the plurality of insulating layers 104 and 105 of the first buildup layer 102 with respect to the core layer 101. Accordingly, the third insulating layer 106 of the second buildup layer 103 may be provided at a position symmetrical to the first insulating layer 104 of the first buildup layer 102 with respect to the core layer 101, and the fourth insulating layer 107 of the second buildup layer 103 may be provided at a position corresponding to the second insulating layer 105 of the first buildup layer 102 with respect to the core layer 101. Accordingly, a problem of warpage of the circuit board and a problem of stress concentration in a specific region, which may occur due to the plurality of insulating layers 104 and 105 of the first buildup layer 102 and the plurality of insulating layers 106 and 107 of the second buildup layer 103 having an asymmetric structure with respect to the core layer 101, may be solved. However, embodiments are not limited thereto. For example, the plurality of insulating layers 104 and 105 of the first buildup layer 102 and the plurality of insulating layers 106 and 107 of the second buildup layer 103 may have an asymmetric structure with respect to the core layer 101, and the problem of warpage of the circuit board or stress concentration in a specific region may be solved through design changes such as a thickness of each insulating layer provided in the circuit board, a thickness and/or wiring density of each circuit layer, a thickness of the first protective layer 108, and a thickness of the second protective layer 109.

The second protective layer 109 may protect the third circuit layer 118 from external moisture or contaminants. In addition, when the semiconductor device is disposed on the circuit board 100 with a material such as solder, the second protective layer 109 functions to prevent a short circuit between adjacent solders due to low wettability with solder. A photocurable insulating material may be used as the second protective layer 109, and for example, a solder resist may be used.

The above-described structure of the circuit board 100 is merely an embodiment for describing the present invention, and the technical spirit of the present invention is not limited to the stacked structure of the present embodiment.

Recently, as functions provided by semiconductor devices increase and performance of semiconductor devices improves, the number of I/O terminals provided in semiconductor devices is increasing and the size of semiconductor devices is increasing. Accordingly, heat generation of semiconductor devices is increasing, and higher heat dissipation characteristics of the circuit board are required. However, as described above, there is a limit to improving heat dissipation characteristics with a via electrode formed by filling a via hole formed through a laser process with a metal material. Specifically, after a plurality of via holes are formed using a laser process, each via hole may be filled with a conductive material so that a plurality of via electrodes connected to one pad are connected to each other. However, due to characteristics of the laser process, the laser process should be performed corresponding to the number of via holes, which may cause a problem in that manufacturing time increases and product yield decreases. Furthermore, the shape of the via hole formed through the laser process depends on a waveform of a laser beam, and thus a degree of freedom in design of the via hole may be reduced. In contrast, in embodiments, a via hole is formed in the second insulating layer 105, and thereafter the via hole is filled with a conductive material to form the via electrode 118. In this case, the via hole may be formed by performing exposure and development processes on the second insulating layer 105, and accordingly, a process time for forming the via hole and the via electrode 118 may be reduced, product yield may be improved, and the via hole and the via electrode 118 may be designed to have optimal heat dissipation performance according to product design, thereby maximizing heat dissipation characteristics while improving design freedom. However, embodiments are not limited to the above-described via electrode 118 being formed only in the second insulating layer 105. When it is possible to form, in the first insulating layer 104, a via electrode corresponding to the structure of the via electrode 118 described below according to laser process capability, the via electrode 118 described below may also be formed in the first insulating layer 104. In this case, the via electrode provided in the first insulating layer 104 may be provided to overlap the cavity provided in the second insulating layer 105 in the vertical direction.

Heat dissipation performance may increase in proportion to a planar area of the via electrode 118. For example, as the planar area of the via electrode 118 increases, heat dissipation characteristics may improve, and as the planar area of the via electrode 118 decreases, heat dissipation characteristics may deteriorate. Accordingly, the planar area of the via electrode 118 may be increased in order to improve heat dissipation characteristics. However, when the planar area of the via electrode 118 is simply increased, a planar area of a corresponding via hole is also increased, such that it may be difficult to densely fill the via hole with a metal material, and accordingly, an empty space such as a void may be formed in the via electrode 118. In addition, the empty space provided in the via electrode 118 may act as a factor that deteriorates heat dissipation characteristics, and warpage of the semiconductor package substrate may occur as a portion having locally high electrode density is formed. When the planar area of the via hole is increased to increase the planar area of the via electrode 118, heat dissipation characteristics may improve, but as the planar area of the via hole increases, it may become difficult to densely fill the inside of the via hole with a conductive material. In addition, the circuit board may be greatly warped in a specific direction according to a difference in wiring density between via electrodes and circuit layers provided in each layer. For example, the circuit board may be greatly warped in a specific direction according to a difference in wiring density between the first circuit layer 110 and the fourth circuit layer 113, a difference in wiring density between the second circuit layer 111 and the fifth circuit layer 114, a difference in wiring density between the third circuit layer 112 and the sixth circuit layer 115, a difference in wiring density between the first via electrode 116 and the third via electrode 120, and a difference in wiring density between the second via electrode 117 and the fourth via electrode 121. In addition, when the via electrode 118 is provided in the second insulating layer 105 of the first buildup layer 102, the wiring density of the second via electrode 117 may be greater than the wiring density of the fourth via electrode 121, and accordingly, the circuit board may be convexly warped upwardly or concavely warped downwardly. Accordingly, when the planar area of the via electrode 118 is simply increased, the circuit board 100 may be greatly warped in a specific direction together with the above-described problem in which a void is provided in the via electrode 118. Accordingly, embodiments provide the via electrode 118 having a structure capable of greatly improving heat dissipation characteristics, preventing a void from being provided in the via electrode 118, and preventing the circuit board from being greatly warped in a specific direction.

Referring to FIG. 1c, the via electrode 118 may be provided to penetrate at least a partial region of the via electrode 118 from an upper surface of the second insulating layer 105 toward a lower surface thereof. The upper surface of the via electrode 118 may be connected to the fourth pad 112P1 of the third circuit layer 112. The upper surface of the via electrode 118 may be located on the same plane as the upper surface of the second insulating layer 105. That is, a via hole corresponding to the via electrode 118 may be provided to penetrate a partial region of the second insulating layer 105 from the upper surface of the second insulating layer 105. Accordingly, when the second insulating layer 105 is used as a photocurable material, exposure and development processes for forming the via hole may be performed from the upper surface of the second insulating layer 105, thereby avoiding a laser process for forming the cavity and the via hole. Accordingly, it is possible to prevent a problem in which an inorganic filler and/or glass fiber of a lower insulating layer is exposed, and thereby solve an electrical reliability problem caused when the via electrode 118 subsequently contacts the inorganic filler and/or glass fiber.

The via electrode 118 is provided to penetrate at least a partial region of the second insulating layer 105, and accordingly overlaps the cavity 105C provided in the second insulating layer 105 in a horizontal direction. In this case, when the cavity 105C is provided in the second insulating layer 105, a planar area of the second insulating layer 105 in the first buildup layer 102 and a planar area of the fourth insulating layer 107 in the second buildup layer 103 may differ from each other, and the circuit board may be greatly warped in a specific direction due to a difference between the planar areas thereof. Accordingly, by providing the via electrode 118 overlapping the cavity 105C in the horizontal direction, the difference between the planar area of the second insulating layer 105 in the first buildup layer 102 and the planar area of the fourth insulating layer 107 in the second buildup layer 103 may be alleviated by a difference in wiring density between the second via electrode 117 including the via electrode 118 and the fourth via electrode 121, thereby preventing the circuit board from being greatly warped in a specific direction. Furthermore, the via electrode 118 may also function as a reinforcing portion improving rigidity of the circuit board 100. In this case, a connection member and/or a semiconductor device may be disposed in the cavity 105C, and the via electrode 118 may improve rigidity of the circuit board in a region overlapping the connection member and/or the semiconductor device in the horizontal direction, thereby allowing the connection member and/or the semiconductor device to operate more stably.

The via electrode 118 includes a through hole 118T. The through hole 118T may penetrate the via electrode 118 from the upper surface of the via electrode 118 toward the lower surface of the via electrode 118. In addition, the through hole 118T provided in the via electrode 118 may be filled with the second insulating layer 105. That is, the through hole 118T provided in the via electrode 118 may refer to a portion in which a via hole is not formed in the second insulating layer 105. The through hole 118T provided in the via electrode 118 may function to control a planar area of the via electrode 118, and accordingly improve processability in a process of filling the via hole with a conductive material, thereby preventing a void from being formed in the via electrode 118. For example, an inner side surface of the through hole 118T may function as a plating bridge in a process of filling the via hole with a conductive material, thereby allowing the via hole to be uniformly filled overall with the conductive material. Furthermore, the through hole 118T provided in the via electrode 118 may function to control wiring density of the second via electrode 117 by adjusting the planar area of the via electrode 118, thereby solving a warpage problem of the circuit board that may occur due to a difference in wiring density between the second via electrode 117 and the fourth via electrode 118.

The through hole 118T provided in the via electrode 118 may be provided in plurality. Preferably, the through hole 118T provided in the via electrode 118 may include a plurality of through holes spaced apart in a first horizontal direction and a plurality of through holes spaced apart in a second horizontal direction different from the first horizontal direction. Accordingly, the via electrode 118 may have an overall plate-shaped planar shape and may have a structure in which the plurality of through holes 118T spaced apart in the first and second horizontal directions are formed therein. That is, the planar shape of the via electrode 118 may have a mesh shape including the through holes 118T. Accordingly, compared to a thermal via electrode including a plurality of circular thermal vias and/or bar-shaped thermal vias spaced apart in the first and second horizontal directions according to a prior art, the via electrode 118 may maximize the planar area within a limited space, thereby further improving heat dissipation characteristics of the circuit board and/or semiconductor package by the via electrode 118. In addition, since the via electrode 118 is provided with the plurality of through holes 118T spaced apart in the first and second horizontal directions, a uniform conductive material filling process may proceed throughout the entire region of the via hole, thereby further improving mechanical reliability and/or electrical reliability of the via electrode 118.

A perimeter of the upper surface of the via electrode 118 may include a plurality of curved portions 118OS1 and a plurality of linear portions 118OS2 connecting the plurality of curved portions to each other. For example, the via electrode 118 may have a structure in which a plurality of first thermal via parts having a circular planar shape and a plurality of second thermal via parts having a quadrangular planar shape are connected to each other, and accordingly, the perimeter of the upper surface of the via electrode 118 may include the curved portions 118OS1 corresponding to the first thermal via parts and the linear portions 118OS2 corresponding to the second thermal via parts. Since the perimeter of the upper surface of the via electrode 118 includes the curved portions 118OS1 and the linear portions 118OS2, an outer side surface of the via electrode 118 may have a step along a circumferential direction of the outer side surface of the via electrode 118. For example, the outer side surface of the via electrode 118 may include a convex portion protruding outwardly (corresponding to the above-described curved portion) and/or a concave portion concave inwardly (corresponding to the above-described linear portion). Accordingly, embodiments may increase a contact area between the via electrode 118 and the second insulating layer 105. Accordingly, embodiments may solve a reliability problem in which the via electrode 118 is delaminated from the second insulating layer 105, thereby improving mechanical reliability and/or electrical reliability of the circuit board and/or semiconductor package.

In this case, the lower surface of the via electrode 118 may be connected to the second pad 111P2 of the second circuit layer 111, and the upper surface of the via electrode 118 may be connected to the fourth pad 112P1 of the third circuit layer 112. In one embodiment, the second pad 111P2 and the fourth pad 112P may be ground pads, and the via electrode 118 may be connected to the ground pads. In this case, heat may be transferred through the ground, thereby further improving heat dissipation characteristics. In addition, when the second pad 111P2 and the fourth pad 112P are ground pads, at least one of the second pad 111P2 and the fourth pad 112P may be disposed to overlap the cavity 105C in the horizontal direction and may also function as a reinforcing portion improving rigidity of the circuit board, thereby allowing the connection member and/or the semiconductor device disposed in the cavity 105C to smoothly operate. However, embodiments are not limited thereto, and the second pad 111P2 and the fourth pad 112P may be pads having functions other than a ground function. An upper surface of the second pad 111P2 includes a first portion contacting the lower surface of the via electrode 118 and a second portion contacting the second insulating layer 105 provided in the through hole 118T of the via electrode 118. In addition, the fourth pad 112P includes a first portion contacting the upper surface of the via electrode 118 and a second portion contacting the second insulating layer 105 provided in the through hole 118T of the via electrode 118. In this case, compared to a case in which the second pad 111P2 and the fourth pad 112P1 contact only the upper surface and/or lower surface of the via electrode 118, a case in which the second pad 111P2 and the fourth pad 112P1 contact both the upper surface of the via electrode 118 and the upper surface of the second insulating layer 105 may have higher bonding force, thereby solving a problem in which the fourth pad 112P is delaminated from the via electrode 118 and/or the second insulating layer 105. In this case, as illustrated in FIG. 1c, the perimeter of the upper surface of the via electrode 118 may be located closer to a perimeter of the upper surface of the circuit board and/or a perimeter of the upper surface of the second insulating layer 105 than a perimeter of the upper surface of the fourth pad 112P. For example, a planar area of the upper surface of the via electrode 118 including the through hole 118T may be smaller than a planar area of the upper surface of the fourth pad 112P. Accordingly, since at least a portion of the via electrode 118 does not overlap the fourth pad 112P in the vertical direction, it is possible to solve a problem in which heat dissipation characteristics by the via electrode 118 are deteriorated, and the semiconductor device may be stably disposed on the fourth pad 112P according to securing of the planar area of the fourth pad 112P. However, embodiments are not limited thereto, and at least a portion of the perimeter of the upper surface of the via electrode 118 may be positioned on the same vertical line as at least a portion of the perimeter of the upper surface of the fourth pad 112P. Accordingly, the planar area of the via electrode 118 may be further increased, thereby further improving heat dissipation characteristics.

According to the embodiment of FIG. 2, the circuit board includes a second insulating layer 201 and a via electrode 205 penetrating at least a partial region of the second insulating layer 201. In addition, a fourth pad 202 connected to the via electrode 205 is disposed on an upper surface of the second insulating layer 201.

The via electrode 205 includes a through hole 204 penetrating an upper surface and a lower surface of the via electrode 205. In addition, a plurality of through hole 204 may penetrate the via electrode 205 at positions spaced apart in the first horizontal direction and the second horizontal direction. A perimeter of the upper surface of the via electrode 205 may have a step. The perimeter of the upper surface of the via electrode 205 may include a first portion 205 and a second portion 206 having a step with each other. Specifically, the first portion 205 and the second portion 206 may be provided in the form of straight lines having a step with each other. The first portion 205 of the via electrode 205 may be referred to as a convex portion protruding outwardly relative to the second portion 206, and the second portion 206 of the via electrode 205 may be referred to as a concave portion concave inwardly relative to the first portion 205. That is, the via electrode 205 may include a plurality of first via parts having a quadrangular planar shape and a plurality of second via parts having a quadrangular planar shape and connecting the plurality of first via parts, and accordingly, the perimeter of the upper surface of the via electrode 205 may include the first portion 205 and the second portion 206 of the linear portions. That is, when the second insulating layer 201 is used as a photocurable material, embodiments may form the via hole in the second insulating layer 201 through exposure and development processes, thereby improving a degree of freedom in design of the planar shape of the via hole and the corresponding via electrode 205. In addition, according to the embodiment of FIG. 2, the via electrode 205 having a planar area larger than the planar area of the via electrode 118 according to the embodiment of FIG. 1c may be provided, thereby further improving heat dissipation characteristics.

According to the embodiments of FIGS. 3a and 3b, the circuit board includes a second insulating layer 301 and a via electrode 304 penetrating at least a partial region of the second insulating layer 301. In addition, a lower pad 302 connected to a lower surface of the via electrode 304 may be provided on a lower surface of the second insulating layer 301, and an upper pad 303 connected to an upper surface of the via electrode 304 may be provided on an upper surface of the second insulating layer 301. In addition, a first protective layer 306 may be disposed on the upper surface of the second insulating layer 301. Here, the lower pad 302 may correspond to the second pad 111P2 in the circuit board of the previous embodiment, and the upper pad 303 may correspond to the fourth pad 112P1 in the circuit board of the previous embodiment.

The via electrode 304 includes a through hole 305 penetrating the upper surface of the via electrode 304 and the lower surface of the thermal via electrode 305. In addition, the through hole 305 may be provided in plurality while penetrating the via electrode 304 at positions spaced apart in the first horizontal direction and the second horizontal direction. A perimeter 304S of the upper surface of the via electrode 304 may not have a step. For example, the perimeter 304S of the upper surface of the via electrode 304 may have a quadrangular shape from which a step is removed. In this case, a shape and/or position of the perimeter 304S of the upper surface of the via electrode 304 may correspond to a shape and/or position of a perimeter 303S of the upper surface of the upper pad 303. The perimeter 304S of the upper surface of the via electrode 304 may be positioned on the same vertical line as the perimeter 303S of the upper surface of the upper pad 303. The embodiments of FIGS. 3a and 3b may provide the via electrode 304 having a planar area larger than planar areas of the via electrodes 118 and 205 according to the embodiments of FIGS. 1c and 2, thereby further improving heat dissipation characteristics.

According to the embodiment of FIG. 4a, the circuit board may include a first insulating layer 401 and a second insulating layer 404 disposed on the first insulating layer 401. In addition, a lower pad 402 may be disposed between an upper surface of the first insulating layer 401 and a lower surface of the second insulating layer 404, and an upper pad 405 may be disposed on an upper surface of the second insulating layer 404. In addition, the first via electrode 403 may be connected to the lower pad 402 and may be provided to penetrate at least a partial region of the first insulating layer 401. In addition, the via electrode 406 may be connected to the lower pad 302 and the upper pad 405 and may be provided to penetrate at least a partial region of the second insulating layer 404. In addition, a first protective layer 407 may be disposed on the second insulating layer 404. In this case, the first insulating layer 401, the second insulating layer 404, the via electrodes 403 and 406, the upper pad 405, and the first protective layer 407 in the circuit board according to the embodiment of FIG. 4a substantially perform the same functions as components having the same names described in the circuit board of the previous embodiment, and thus redundant descriptions thereof will be omitted.

The lower pad 402 is connected to a lower surface of the via electrode 406 and may include an open portion 409 in which a region vertically overlapping the through hole 408 provided in the via electrode 406 is open. In this case, the open portion 409 may refer to a through hole provided in the lower pad 402 or may refer to a spaced region between a plurality of pads.

That is, according to the embodiment of FIG. 4b, the via electrode 406 is disposed on the lower pad 402. In this case, the via electrode 406 may include the through hole 408, and the lower pad 402 may include the open portion 409 overlapping the through hole 408 of the via electrode 406 in the vertical direction. The open portion 409 of the lower pad 402 may penetrate between an upper surface of the lower pad 402 and a lower surface of the lower pad 402 corresponding to the through hole 408 of the via electrode 406. In this case, the open portion 409 provided in the lower pad 402 may function as a gas discharge hole through which gas generated during a process of manufacturing the circuit board is discharged. For example, a process of manufacturing the circuit board includes a process of curing the first insulating layer 401 after stacking the first insulating layer 401, and gas may be generated during curing of the first insulating layer 401. In this case, when the lower pad 402 not including the open portion 409 is provided on the upper surface of the first insulating layer 401, the above-described gas may not be smoothly discharged upwardly from the first insulating layer 401. In addition, when the above-described gas is not smoothly discharged, a problem in which an interface between the first insulating layer 401 and the second insulating layer 404 and/or an interface between the first insulating layer 401 and the lower pad 402 swells may occur, and a delamination problem due thereto may occur. The open portion 409 provided in the lower pad 402 according to the embodiment may function as a gas outlet through which gas generated during curing of the first insulating layer 401 is discharged, and accordingly, the above-described gas may be smoothly discharged, thereby further improving mechanical reliability and/or electrical reliability of the circuit board and/or semiconductor package.

In addition, a diameter and/or planar area of the open portion 409 of the lower pad 402 may be smaller than a diameter and/or planar area of the through hole 408 of the via electrode 406. Accordingly, at least a portion of the through hole 408 may overlap the upper surface of the lower pad 402 in the vertical direction, and a remaining portion of the through hole 408 may overlap the open portion 409 of the lower pad 402 in the vertical direction. Accordingly, embodiments may allow an entirety of the lower surface of the via electrode 406 to contact the lower pad 402, thereby further improving heat dissipation characteristics.

According to the embodiment of FIG. 4c, the lower pads 402 may be provided in plurality while being spaced apart from each other, and the open portion 409 may be a spaced region between the plurality of lower pads. Accordingly, embodiments may allow heat dissipation through the plurality of lower pads 402 so that a heat transfer path is branched into a plurality of paths, and heat may be transferred through the plurality of branched paths, thereby further improving heat dissipation characteristics.

In the circuit board 100A according to the embodiment of FIG. 5, the via electrode 116A having the same structure as the via electrodes 117, 203, 304, and 406 including the through hole described with reference to FIGS. 1a to 4c may be provided in the first insulating layer 104. For example, a via hole may be formed in the first insulating layer 104 through a laser process, and accordingly, when a via hole having a design corresponding to the via electrodes 117, 203, 304, and 406 may be formed in the first insulating layer 104 according to laser process capability, the via electrode 116A having a structure corresponding to the via electrodes 117, 203, 304, and 406 may also be formed in the first insulating layer 104.

Accordingly, in one embodiment, the circuit board may have a structure in which the above-described via electrodes 117, 203, 304, and 406 are disposed only in the second insulating layer 105, and in this case, the via electrodes 117, 203, 304, and 406 may have a structure overlapping the cavity in the horizontal direction. In another embodiment, the circuit board may have a structure in which the via electrodes 117, 203, 304, 406, and 116A are disposed in each of the first insulating layer 104 and the second insulating layer 105, and in this case, some of the via electrodes 117, 203, 304, 406, and 116A may overlap the cavity in the horizontal direction and the remaining portions may overlap the cavity in the vertical direction. In still another embodiment, the circuit board may have a structure in which the via electrode 116A is disposed in the first insulating layer 104, and in this case, the via electrode 116A may have a structure overlapping the cavity in the vertical direction.

According to the embodiments of FIGS. 6a and 6b, the circuit board includes a second insulating layer 501, an upper pad 504 disposed on the second insulating layer 501, a protective layer 508 disposed on the upper pad 504, and a via electrode 505 penetrating at least a partial region of the second insulating layer 501. The via electrode 505 may correspond to any one of the via electrodes illustrated in FIGS. 1c, 2, and 3. Although the via electrode 505 in FIG. 6 is illustrated as having a shape corresponding to the via electrode 203 of FIG. 2, embodiments are not limited thereto, and the via electrode 505 may also have a shape corresponding to the thermal via electrode illustrated in FIG. 1c or FIG. 3. The via electrode 505 may include a plurality of through holes 506 spaced apart in the first and second horizontal directions. The second insulating layer 501 may be divided into a plurality of portions. The second insulating layer 501 may include a first portion 502 disposed in the through holes 506 provided in the via electrode 505 and a second portion 503 other than the first portion 502. In this case, the second insulating layer 501 may include a via hole penetrating an upper surface and a lower surface of the second portion 503. The via hole provided in the second portion 503 of the second insulating layer 501 may correspond to the via electrode 505, and the via electrode 505 may be formed by filling the via hole provided in the second portion 503 of the second insulating layer 501 with a conductive material. In addition, the second insulating layer 501 may further include a sub via hole penetrating an upper surface and a lower surface of the first portion 502 while not being connected to the above-described via hole. In addition, a sub via electrode 507 may be formed by filling the sub via hole formed in the first portion 502 of the second insulating layer 501 with a conductive material. That is, the sub via electrode 507 may be disposed in the through hole 506 provided in the via electrode 505 and/or the via hole provided in the first portion 502 of the second insulating layer 501 and may not be connected to the via electrode 505. That is, the first portion 502 of the second insulating layer 501 may be disposed between an inner side surface of the through hole 506 of the via electrode 505 and an outer side surface of the sub via electrode 507, and accordingly, may be provided to surround the outer side surface of the sub via electrode 507 so that the via electrode 505 and the sub via electrode 507 do not directly contact each other. In this case, the through hole 506 provided in the via electrode 505 may be provided to improve processability in a process of filling the via hole provided in the second insulating layer 501 with a conductive material. However, the planar area of the via electrode 505 may be reduced by the planar area of the through hole 506 provided in the via electrode 505, and accordingly, heat dissipation characteristics may deteriorate. Accordingly, in embodiments, the sub via electrode 507 may be further disposed in the through hole 506 of the via electrode 505. The sub via electrode 507 is not connected to the via electrode 505, and accordingly, may not affect processability in a conductive material filling process for forming the via electrode 505. Furthermore, the planar area of the via electrode may be increased by the planar area of the sub via electrode 507, thereby further improving heat dissipation characteristics of the circuit board and semiconductor package.

According to the embodiments of FIGS. 7a and 7b, the circuit board includes a second insulating layer 501, an upper pad 504 disposed on the second insulating layer 501, a protective layer 508 disposed on the upper pad 504, and a via electrode 505 penetrating at least a partial region of the second insulating layer 501.

In addition, the second insulating layer 501 may be divided into a plurality of portions. The second insulating layer 501 may include a first portion 502 disposed in the through hole 506 provided in the via electrode 505 and a second portion 503 other than the first portion 502. In this case, the second insulating layer 501 may include a via hole penetrating an upper surface and a lower surface of the second portion 503. The via hole provided in the second portion 503 of the second insulating layer 501 may correspond to the via electrode 505, and the via electrode 505 may be formed by filling the via hole provided in the second portion 503 of the second insulating layer 501 with a conductive material. In addition, the second insulating layer 501 may further include a sub via hole penetrating an upper surface and a lower surface of the first portion 502 while not being connected to the above-described via hole. In addition, the sub via electrode 509 may be formed by filling the sub via hole formed in the first portion 502 of the second insulating layer 501 with a conductive material.

In this case, in the circuit board according to the embodiments of FIGS. 6a and 6b, a center axis in the horizontal direction of the through hole 506 provided in the via electrode 505 and a center axis in the horizontal direction of the sub via electrode 507 disposed in the above-described through hole 506 may coincide with each other.

Unlike this, in the circuit board according to the embodiments of FIGS. 7a and 7b, a center axis X1 in the horizontal direction of the through hole 506 provided in the via electrode 505 and a center axis X2 in the horizontal direction of the sub via electrode 509 disposed in the above-described through hole 506 may be offset from each other. For example, a horizontal distance W1 between an outer side surface of the sub via electrode 509 and an inner side surface of the via electrode 505 at one side of the sub via electrode 509 and a horizontal distance W2 between the outer side surface of the sub via electrode 509 and the inner side surface of the via electrode 505 at another side of the sub via electrode 509 may differ from each other. For example, a horizontal distance between the inner side surface of the via electrode 505 and the inner side surface of the sub via electrode 509 may include a first horizontal distance and a second horizontal distance W1 and W2 different from each other along a circumferential direction of the outer side surface of the sub via electrode 509. Accordingly, embodiments may allow the sub via electrode 509 to be eccentrically disposed in a specific horizontal direction within the through hole 506 of the via electrode 505, thereby further improving processability of the circuit board. Furthermore, embodiments may allow the sub via electrode 509 to be eccentrically disposed in a specific horizontal direction within the through hole 506 of the via electrode 505, thereby further improving prevention of the circuit board from being greatly warped in a specific direction. For example, the via electrode 505 includes a plurality of through holes 506 and sub via electrodes 509, and directions in which center axes in the horizontal direction of the plurality of through holes 506 and the plurality of sub via electrodes 509 are offset from each other may differ from each other. For example, a center axis in the horizontal direction of the sub via electrode 509 positioned adjacent to a left side surface of the via electrode 505 may be offset rightward with respect to a center axis in the horizontal direction of the through hole 506, and a center axis in the horizontal direction of the sub via electrode 509 positioned adjacent to a right side surface of the via electrode 505 may be offset leftward with respect to the center axis in the horizontal direction of the through hole 506. Accordingly, embodiments may prevent the circuit board from being warped in a specific direction by controlling a direction in which the center axis in the horizontal direction of the sub via electrode 509 and the center axis in the horizontal direction of the through hole 506 are offset from each other, and furthermore may further improve mechanical reliability and/or electrical reliability of the circuit board and semiconductor package. According to the embodiment of FIG. 8, the circuit board includes a core layer 601, a core via electrode 610 penetrating the core layer 601, an insulating member 611 disposed inside the core via electrode 610, and a first buildup layer disposed on the core layer 601. The first buildup layer includes a plurality of insulating layers 602, 603, and 604, a first protective layer 605, a plurality of circuit layers 606, 607, 608, and 609, a plurality of via electrodes 612, 613, and 614, and a bonding portion 615. Each component of the circuit board according to the embodiment of FIG. 8 substantially performs the same function as a component having the same name described in the circuit board of the previous embodiment, and thus redundant descriptions thereof will be omitted.

The plurality of insulating layers 602, 603, and 604 may include a first-first insulating layer 602 disposed on the core layer 601, a first-second insulating layer 603 disposed on the first-first insulating layer 602, and a second insulating layer 604 disposed on the first-second insulating layer 603. Here, although it is illustrated that two first insulating layers are disposed between the core layer 601 and the second insulating layer 604, this is for describing differences in widths, inclination angles, and thicknesses of via electrodes provided in respective insulating layers, and the structure of the present embodiment is not limited thereto.

The first-first insulating layer 602 may be disposed on the core layer 601 and may be provided as a thermosetting insulating material including a reinforcing member, and for example, may be prepreg. The first-second insulating layer 603 may be disposed on the first-first insulating layer 602 and may be provided as a thermosetting insulating material not including a reinforcing member, and for example, may be ABF. In this case, only one of the first-first insulating layer 602 and the first-second insulating layer 603 may be provided on the core layer 601 as a single layer or a plurality of layers. In addition, when the first-first insulating layer 602 and the first-second insulating layer 603 are respectively disposed between the core layer 601 and the second insulating layer 604, the first-first insulating layer 602 including the reinforcing member may be disposed closer to the core layer 601 than the first-second insulating layer 603. That is, an elastic modulus and/or coefficient of thermal expansion of the first-first insulating layer 602 including the reinforcing member may be smaller than an elastic modulus and/or coefficient of thermal expansion of the first-second insulating layer 603 not including the reinforcing member. Accordingly, the first-first insulating layer 602 having a relatively small elastic modulus and/or coefficient of thermal expansion is disposed closer to the core layer 601 than the first-second insulating layer 603, thereby further buffering stress applied to the circuit board due to a difference in elastic modulus and/or coefficient of thermal expansion between the above-described core layer 601 and the second insulating layer 604.

The first via electrode 612 may penetrate at least a partial region of the first-first insulating layer 602. The second via electrode 613 may penetrate at least a partial region of the first-second insulating layer 603. The third via electrode 614 may penetrate at least a partial region of the second insulating layer 604. The third via electrode 614 may include the above-described via electrode having a heat dissipation function and a via electrode having a signal and/or power transfer function, and FIG. 8 may illustrate only the via electrode having the signal and/or power transfer function among them. An inclination angle, a thickness in the vertical direction, and/or a width in the horizontal direction of at least one among the first via electrode 612, the second via electrode 613, and the third via electrode 614 may differ from an inclination angle, a thickness in the vertical direction, and/or a width in the horizontal direction of at least another one of the via electrodes.

In this case, a thickness H1 in the vertical direction of the first via electrode 612 may differ from a thickness H2 in the vertical direction of the second via electrode 613 and a thickness H3 in the vertical direction of the third via electrode 614. The thickness H1 in the vertical direction of the first via electrode 612 may be equal to or greater than the thickness H2 in the vertical direction of the second via electrode 613 and the thickness H3 in the vertical direction of the third via electrode 614. For example, the thickness H1 in the vertical direction of the first via electrode 612 may be 15 µm or more, and each of the thickness H2 in the vertical direction of the second via electrode 613 and the thickness H3 in the vertical direction of the third via electrode 614 may be 10 µm or more. That is, the first-first insulating layer 602 includes the reinforcing member, and accordingly, there is a limitation in reducing the thickness in the vertical direction of the first-first insulating layer 602. This is because, when the thickness in the vertical direction of the first-first insulating layer 602 decreases, the reinforcing member provided in the first-first insulating layer 602 may be exposed and contact the circuit layer, thereby deteriorating electrical characteristics. In addition, since the first via electrode 612 penetrates at least a partial region of the first-first insulating layer 602, the thickness H1 in the vertical direction thereof may be equal to or greater than the thickness H2 in the vertical direction of the second via electrode 613 provided in the first-second insulating layer 603 not including the reinforcing member and the thickness H3 in the vertical direction of the third via electrode 614 provided in the second insulating layer 604. Accordingly, the first via electrode 612, which may have a relatively large thickness, is disposed closest to the core via electrode 610 provided in the core layer 601, thereby minimizing signal transmission loss that may occur due to a difference in thicknesses in the vertical direction of the via electrodes stacked along the vertical direction.

In addition, a width W3 in the horizontal direction of the third via electrode 614 may differ from a width W1 in the horizontal direction of the first via electrode 612 and a width W2 in the horizontal direction of the second via electrode 613. For example, the width W3 in the horizontal direction of the third via electrode 614 may be equal to or smaller than the width W1 in the horizontal direction of the first via electrode 612 and the width W2 in the horizontal direction of the second via electrode 613. That is, the third via electrode 614 is formed by filling a via hole formed through exposure and development processes with a conductive material, and accordingly, may have the width W3 in the horizontal direction smaller than the width W1 in the horizontal direction of the first via electrode 612 and the width W2 in the horizontal direction of the second via electrode 613, which are formed by filling via holes formed through a laser process with a conductive material. Accordingly, embodiments may allow the third via electrode 614 having the relatively small width W3 in the horizontal direction to be provided at a position farthest from the core layer 601, and accordingly may miniaturize a width and/or pitch in the horizontal direction of the circuit layer 609 disposed on the third via electrode 614.

In addition, each of the first via electrode 612, the second via electrode 613, and the third via electrode 614 may have an inclination in which a width in the horizontal direction gradually decreases along a direction from an upper surface toward a lower surface thereof. In addition, an inclination angle θ of the third via electrode 614 may differ from an inclination angle θ of the first via electrode 612 and an inclination angle θ of the second via electrode 613. The inclination angle θ of the third via electrode 614 may be equal to or smaller than the inclination angle θ of the first via electrode 612 and the inclination angle θ of the second via electrode 613. For example, the inclination angle θ of the first via electrode 612 and the inclination angle θ of the second via electrode 613 may range from 75° to 85°. In addition, the inclination angle θ of the third via electrode 614 may range from 70° to 80°. This is because a de-smear process is performed after forming the via hole in the second insulating layer 604, and through the de-smear process, the inclination angle θ of the third via electrode 614 has a range different from the inclination angle θ of the first via electrode 612 and the inclination angle θ of the second via electrode 613. Accordingly, embodiments may allow the third via electrode 614 to have a relatively gentle inclination angle, thereby further improving adhesion between the second insulating layer 604 and the third via electrode 614. The second insulating layer 604 may have an elastic modulus and/or coefficient of thermal expansion greater than those of each of the core layer 601, the first-first insulating layer 602, and the first-second insulating layer 603, and accordingly, greater stress may act thereon due to expansion and/or contraction according to a heat cycle. Accordingly, by allowing the third via electrode 614 to have a relatively gentle inclination, a contact area between the second insulating layer 604 and the third via electrode 614 may be increased, thereby securing adhesion therebetween.

In addition, a partial region of the circuit layer 609 disposed on the second insulating layer 604 may include a pad portion exposed from the first protective layer 605. In addition, as density of terminals of the semiconductor device increases, a short-circuit problem of solder may occur between adjacent pad portions when conventional solder bonding is used. Accordingly, in order to reduce an amount of solder used as density of terminals of the semiconductor device increases, the semiconductor device and the circuit board 100 may be coupled to each other through a thermal compression bonding (TC bonding) method. When TC bonding is used, the circuit board 100 may further include a bonding portion 615 protruding on the first protective layer 605. The bonding portion 615 may include a protrusion 616 protruding above an upper surface of the first protective layer 605 and a through portion 617 penetrating the first protective layer 605 and connected to the circuit layer 609. In addition, when the circuit board 100 and the semiconductor device are coupled through TC bonding, a crack may occur in the through portion 617 of the bonding portion 615 due to a load generated thereby. Accordingly, the through portion 617 of the bonding portion 615 may prevent a crack by disposing, in a portion adjacent to the circuit layer 609, a material having an elastic modulus greater than that of the circuit layer 609. Such a material may use nickel (Ni), or a copper layer having low grain density through electroless plating may be disposed.

The protrusion 616 and the through portion 617 of the bonding portion 615 illustrated in FIG. 8 may be disposed in various manners. For example, a process of exposing and developing the first protective layer 605 to form an opening of the first protective layer 605, and thereafter disposing the protrusion 616 and the through portion 617 of the bonding portion 615 in the opening may be performed. In addition, a process of forming a through hole of the first protective layer 605 using a laser and thereafter disposing the bonding portion 615 and the through portion 617 in the opening may be performed. In addition, by using a DFR (Dry Film Resist), the DFR may first be disposed in a region in which the through portion 617 is to be disposed, thereafter the first protective layer 605 may be disposed to cover the DFR, a portion of the first protective layer 605 may then be etched with a chemical solution to expose the DFR, and thereafter the DFR may be peeled off to form an opening in the first protective layer 605, and subsequently the protrusion 616 and the through portion 617 of the bonding portion 615 may be disposed. Accordingly, the through portion 617 may have various shapes according to the process method. For example, when the opening of the first protective layer 605 is formed through an exposure process, a side surface of the through portion 617 may have a structure in which a width thereof gradually decreases toward the circuit layer 609. When the opening of the first protective layer 605 is formed through a laser process, the side surface of the through portion 617 may have a vertical side surface and a curved portion recessed inwardly at a portion adjacent to the circuit layer 609. When the opening of the first protective layer 605 is formed using the DFR, the side surface of the through portion 617 may have only a vertical side surface. As described above, when the semiconductor device is bonded to the circuit board 100 through TC bonding, a load may be applied to the through portion 617. In this case, in the case of the through portion 617 formed using the DFR, stress may be uniformly applied, thereby improving manufacturing yield.

According to the embodiment of FIG. 9, a plurality of second insulating layers may be disposed on one side of the core layer, and in this case, structures of via electrodes and cavities provided in the plurality of second insulating layers may differ from those described in the previous embodiments.

Referring to FIG. 9, the circuit board includes a core layer 701, a first insulating layer 702 disposed on the core layer 701, a second insulating layer 703 disposed on the first insulating layer 702, and a first protective layer 706 disposed on the second insulating layer 703. In addition, the circuit board includes a plurality of circuit layers 707, 708, 709, and 710 respectively disposed on the core layer 701, the first insulating layer 702, and the second insulating layer 703, and via electrodes 713, 714, and 715 connecting the plurality of circuit layers 707, 708, 709, and 710. In addition, a core via electrode 711 is provided in the core layer 701, and an insulating member 712 is provided inside the core via electrode 711. Each component of the circuit board according to the embodiment of FIG. 9 substantially performs the same function as a component having the same name described in the circuit board of the previous embodiment, and redundant descriptions thereof will be omitted.

The core layer 701, the first insulating layer 702, and the second insulating layer 703 may be sequentially stacked along the vertical direction. In this case, the second insulating layer 703 may be provided in a plurality of layers. That is, the second insulating layer 703 may include a second-first insulating layer 704 disposed on the first insulating layer 702 and a second-second insulating layer 705 disposed on the second-first insulating layer 704. When the second insulating layer 703 is provided as a single layer, fine patterns may be intensively disposed in the single second insulating layer, and accordingly, a planar area of the circuit board may increase, or a length of a signal transmission line may increase, thereby increasing signal transmission loss. This is because the signal transmission line is connected only by traces in one layer without via electrodes. Accordingly, the second-first insulating layer 704 and the second-second insulating layer 705 are sequentially disposed on the first insulating layer 702, and miniaturization of the circuit layers 709 and 710 respectively disposed in the second-first insulating layer 704 and the second-second insulating layer 705 is enabled. Therefore, embodiments may further improve circuit integration density of the circuit board and may significantly improve signal transmission characteristics by reducing a length of the signal transmission line.

A cavity 705C may be provided in the second insulating layer 703. In particular, among the second insulating layers 703 in the embodiment of FIG. 9, the second-first insulating layer 704 may not include a cavity, and only the second-second insulating layer 705 may include the cavity 705C. In addition, a sidewall of the cavity 705C provided in the second-second insulating layer 705 may correspond to the sidewall 105C1 of the cavity 105C in FIG. 1b. In this case, a portion of the circuit layer 709 disposed on the second-first insulating layer 704 may overlap the cavity 705C in the vertical direction, and accordingly may function as a mounting pad for mounting a connection member and/or a semiconductor device. In this case, since the mounting pad is disposed on the second-first insulating layer 704, a width and/or pitch in the horizontal direction of the above-described mounting pad may be miniaturized.

In addition, a plurality of via electrodes 714 and 715 may be disposed in each of the second insulating layers 703, and at least one among the plurality of via electrodes 714 and 715 may include a via electrode 716 including the above-described through hole. For example, the cavity 705C is provided in the second-second insulating layer 705, and the via electrode 716 may be disposed in the second-second insulating layer 705 overlapping the cavity 705C in the horizontal direction. In this case, the via electrode 715 provided in the second-second insulating layer 705 may further include a via electrode 717 spaced apart from the via electrode 716 in the horizontal direction and configured to transfer a signal and/or power or not including a through hole.

According to the embodiment of FIG. 10, the circuit board may include a first insulating layer 801, a second-first insulating layer 802 disposed on the first insulating layer 801, and a second-second insulating layer 803 disposed on the second-first insulating layer 802. In addition, a first protective layer 804 may be disposed on the second-second insulating layer 803. In addition, a first circuit layer 805 may be disposed on an upper surface of the first insulating layer 801, a second circuit layer 806 may be disposed on an upper surface of the second-first insulating layer 802, and a third circuit layer 807 may be disposed on an upper surface of the second-second insulating layer 803. In addition, a first via electrode 807 may be disposed to penetrate at least a partial region of the second-first insulating layer 802, and a second via electrode 808 may be disposed to penetrate at least a partial region of the second-second insulating layer 803.

Each of the first via electrode 807 and the second via electrode 808 may be provided in plurality while being spaced apart from each other in the horizontal direction. In addition, according to wiring design, at least one among the plurality of first via electrodes 807 may overlap at least one among the plurality of second via electrodes 808 in the vertical direction. In addition, at least another one among the plurality of first via electrodes 807 may not overlap the plurality of second via electrodes 808 in the vertical direction, and at least another one among the plurality of second via electrodes 808 may not overlap the plurality of first via electrodes 807 in the vertical direction.

In this case, the first via electrode 807 and the second via electrode 808 not overlapping each other in the vertical direction may be individually formed during a manufacturing process of the circuit board. For example, the first via electrode 807 and the second via electrode 808 not overlapping each other in the vertical direction may have a structure in which the first circuit layer 805, the first via electrode 807, the second circuit layer 806, the second via electrode 808, and the third circuit layer 807 are stacked along the vertical direction, and accordingly may be electrically connected to each other.

Furthermore, in a prior art, even in the case of the first via electrode 807 and the second via electrode 808 overlapping each other in the vertical direction, individual manufacturing processes were performed, and accordingly had a structure in which the second circuit layer 806 connecting the first via electrode 807 and the second via electrode 808 was disposed therebetween. In this case, since manufacturing processes for individually forming the first via electrode 807 and the second via electrode 808 need to be performed, manufacturing time may increase and product yield may deteriorate.

Accordingly, the circuit board according to embodiments may further include a third via electrode 809 overlapping each of the first via electrode 807 and the second via electrode 808 in the horizontal direction. The third circuit layer 807 may be provided to overlap the first via electrode 807, the second via electrode 808, and the second circuit layer 806 in the horizontal direction. Specifically, a plurality of via holes may be provided in the second-first insulating layer 802. The plurality of via holes may include a first via hole not overlapping the second via electrode 808 in the vertical direction and a second via hole 802T overlapping the second via electrode 808 in the vertical direction. In addition, during the manufacturing process of the circuit board, the above-described first via hole may be filled with a conductive material, thereby forming the first via electrode 807. Unlike this, during the manufacturing process of the circuit board, the above-described second via hole 802T may not be filled with a conductive material. This may be implemented by opening the first via hole through a dry film while covering the second via hole 802T. Thereafter, the second via hole 802T not filled with the conductive material may be filled with the second-second insulating layer 803 stacked on the second-first insulating layer 802. Accordingly, the second-second insulating layer 803 may include a protrusion 803P filling the second via hole 802T provided in the second-first insulating layer 802. In addition, a plurality of via holes may be provided in the second-second insulating layer 803, and at least one among the plurality of via holes may penetrate from an upper surface of the second-second insulating layer 803 to a lower surface of the protrusion 803P of the second-second insulating layer 803, thereby exposing the first circuit layer 805 disposed on the first insulating layer 801. In addition, the third via electrode 809 may be formed by filling the via hole penetrating from the upper surface of the second-second insulating layer 803 to the lower surface of the protrusion 803P of the second-second insulating layer 803 with a conductive material. Accordingly, the third via electrode 807 may directly connect the first circuit layer 805 and the third circuit layer 807 while having an inclination in which a width in the horizontal direction gradually decreases from an upper surface of the third via electrode 809 toward a lower surface thereof. Therefore, embodiments may simplify the manufacturing process of the circuit board and improve product yield. Furthermore, embodiments may directly connect the first circuit layer 805 and the third circuit layer 807 using the third via electrode 809, thereby further improving signal transmission characteristics.

According to the embodiment of FIG. 11a, the circuit board includes a core layer 901, a first insulating layer 902 disposed on the core layer 901, a second insulating layer 903 disposed on the first insulating layer 902, and a first protective layer 906 disposed on the second insulating layer 903. In addition, the circuit board includes a plurality of circuit layers 907, 908, 909, and 910 respectively disposed on the core layer 901, the first insulating layer 902, and the second insulating layer 903, and via electrodes 913, 914, and 917 connecting the plurality of circuit layers 907, 908, 909, and 910. In addition, a core via electrode 911 is provided in the core layer 901, and an insulating member 912 is provided inside the core via electrode 911. The second insulating layer 903 may include a second-first insulating layer 904 disposed on the first insulating layer 902 and a second-second insulating layer 905 disposed on the second-first insulating layer 904.

In this case, via electrodes 914 and 917 may be disposed in each of the second-first insulating layer 904 and the second-second insulating layer 905. A first via electrode 917 disposed in the second-second insulating layer 905 may further include a via electrode 918 horizontally overlapping a cavity 905C provided in the second-second insulating layer 905 and including the above-described through hole, and a via electrode 919 not including a through hole or having a signal and/or power transfer function. In addition, the second via electrode 914 provided in the second-first insulating layer 904 may also include via electrodes 915 and 916. Specifically, the first via electrode 914 provided in the second-first insulating layer 904 may further include a via electrode 915 vertically overlapping the via electrode 918 provided in the second-second insulating layer 905. Specifically, the circuit board may include a plurality of via electrodes 915 and 918 stacked along the vertical direction. Accordingly, heat dissipation characteristics of the circuit board and semiconductor package may be further improved, and the semiconductor device may operate more stably.

According to the embodiment of FIG. 11b, the circuit board may differ from the structure of the embodiment of FIG. 11a in an arrangement structure of the via electrodes 915 and 918. In the embodiment of FIG. 11a, the via electrodes 915 and 918 may be respectively provided in the second-first insulating layer 904 and the second-second insulating layer 905 and may have a structure connected to each other through a pad of the circuit layer 909 disposed between the second-first insulating layer 904 and the second-second insulating layer 905.

Unlike this, according to the embodiment of FIG. 11b, a via hole 904T may be provided in the second-first insulating layer 904, and the second-second insulating layer 905 may be provided to fill the via hole 904T of the second-first insulating layer 904. That is, the second-second insulating layer 905 may include a protrusion disposed in the via hole 904T of the second-first insulating layer 904. In addition, the via electrode 918 provided in the second-second insulating layer 905 may penetrate from an upper surface of the second-second insulating layer 905 to a lower surface of the protrusion of the second-second insulating layer 905. That is, the via electrode 918 may be provided to directly connect the circuit layer 908 disposed on the upper surface of the first insulating layer 902 and the circuit layer 910 disposed on the upper surface of the second-second insulating layer 905. Furthermore, the via electrode 919 not including the through hole and provided in the second-second insulating layer 905 may also penetrate from the upper surface of the second-second insulating layer 905 to the lower surface of the protrusion of the second-second insulating layer 905 while having a structure corresponding to the via electrode 918 including the through hole.

According to the embodiment of FIG. 11c, the first via electrode 914 provided in the second-first insulating layer 904 may include a via electrode 915 including a through hole and a via electrode 916 not including a through hole, and the via electrode 915 including the through hole may be provided in plurality while being spaced apart from each other in the horizontal direction. Specifically, the via electrode 915 including the through hole may further include a first via electrode portion 915a connected to the via electrode 918 provided in the second-second insulating layer 905 while overlapping the via electrode 918 in the vertical direction, and a second via electrode portion 915b overlapping the first via electrode portion 915a in the horizontal direction. The second via electrode portion 915b may be spaced apart from the first via electrode portion 915a in the horizontal direction and may overlap the cavity 905C in the vertical direction. In addition, the second via electrode portion 915b may be provided for heat dissipation of a semiconductor device to be disposed in the cavity 905C. Accordingly, embodiments may facilitate heat dissipation of a plurality of semiconductor devices by providing a plurality of via electrodes at different positions of the circuit board, thereby further improving heat dissipation characteristics of the circuit board and the semiconductor package including the same.

According to the embodiment of FIG. 11d, a cavity 903C may be provided in the second-first insulating layer 904 and the second-second insulating layer 905. The cavity 903C may be respectively provided in the second-first insulating layer 904 and the second-second insulating layer 905. That is, the cavity 903C may include a first portion 904C provided in the second-first insulating layer 904 and a second portion 905C provided in the second-second insulating layer 905. Accordingly, embodiments may allow the cavity 903C to include the first portion 904C and the second portion 905C provided in different second insulating layers, thereby facilitating adjustment of a depth of the cavity 903C corresponding to a thickness of a connection member and/or a semiconductor device to be disposed in the cavity 903C, and accordingly allowing the connection member and/or the semiconductor device to be more stably disposed in the cavity 903C. In addition, each of the first portion 904C and the second portion 905C of the cavity 903C may have a sidewall inclination angle as illustrated in FIG. 1b. However, the inclination angle of the sidewall of the first portion 904C and the inclination angle of the sidewall of the second portion 905C may differ from each other. For example, the inclination angle of the sidewall of the first portion 904C may be gentler than the inclination angle of the sidewall of the second portion 905C, or conversely, the inclination angle of the sidewall of the second portion 905C may be gentler than the inclination angle of the sidewall of the first portion 904C, and this may be variously designed according to a type of semiconductor device to be disposed in the cavity 903C.

In addition, a width in the horizontal direction of the first portion 904C of the cavity 903C may differ from a width in the horizontal direction of the second portion 905C. That is, each of the first portion 904C and the second portion 905C of the cavity 903C may have an inclination such that a width in the horizontal direction changes along the vertical direction. In this case, the width in the horizontal direction of the first portion 904C at the upper surface of the second-first insulating layer 904 may differ from the width in the horizontal direction of the second portion 905C at the lower surface of the second-second insulating layer 905. For example, the width in the horizontal direction of the first portion 904C at the upper surface of the second-first insulating layer 904 may be greater than the width in the horizontal direction of the second portion 905C at the lower surface of the second-second insulating layer 905. That is, the sidewall of the first portion 904C and the sidewall of the second portion 905C of the cavity 903C may have a step difference. Accordingly, embodiments may further improve adhesion with a molding member molding the cavity 903C, thereby allowing the connection member and/or the semiconductor device disposed in the cavity 903C to be more stably protected.

A semiconductor device may be mounted on the above-described circuit board and provided as a semiconductor package.

According to the embodiment of FIG. 12, the semiconductor package may include a circuit board 1000 and semiconductor devices 1002 and 1004 mounted on the circuit board 1000. The circuit board 1000 may be any one of the circuit boards described with reference to FIGS. 1a to 11, and for example may be the circuit board illustrated in FIG. 1a, but embodiments are not limited thereto.

The plurality of circuit layers provided in the circuit board 1000 may include a first mounting portion overlapping the cavity in the vertical direction and provided in the cavity, and a first bonding member 1001 may be disposed on the first mounting portion. Here, the first mounting portion is a pad for mounting a first semiconductor device 1002, and may be, for example, the first pad 111P1 illustrated in FIG. 1a. In addition, the first semiconductor device 1002 may be attached on the first bonding member 1001. Embodiments allow the first semiconductor device 1002 to be disposed in the cavity provided in the circuit board, thereby reducing a thickness in the vertical direction of the circuit board 1000 by a depth of the cavity.

In addition, the plurality of circuit layers provided in the circuit board may include a second mounting portion disposed on the via electrode including the through hole, and a second bonding member 1003 may be disposed on the second mounting portion. In addition, a second semiconductor device 1004 may be attached on the second bonding member 1003. In this case, the second mounting portion may be a pad connected to the via electrode including the through hole, and may be, for example, the fourth pad 112P1 illustrated in FIG. 1a, but embodiments are not limited thereto. When the second mounting portion is the fourth pad 112P1, a size of the via electrode including the through hole may correspond to a size of the second semiconductor device 1004. Here, the size of the via electrode including the through hole may refer to an overall planar area of the via electrode including a planar area of the above-described through hole. The via electrode may be connected to the second semiconductor device 1004 and may function to dissipate heat generated from the second semiconductor device 1004. In addition, the via electrode may overlap the cavity in the horizontal direction and may function to improve rigidity of the circuit board so that the first semiconductor device 1002 is stably attached. Accordingly, embodiments may allow the first and second semiconductor devices 1002 and 1004 to be stably attached, and accordingly allow the first and second semiconductor devices 1002 and 1004 to operate stably.

In addition, the semiconductor package may further include a molding member 1005 molding the first and second semiconductor devices 1002 and 1004. The molding member 1005 may mold the first and second semiconductor devices 1002 and 1004 at once as a whole, but embodiments are not limited thereto. For example, the molding member 1005 may be provided in plurality while being spaced apart from each other in the horizontal direction, and accordingly may individually mold the first and second semiconductor devices 1002 and 1004. Accordingly, the first and second semiconductor devices 1002 and 1004 may be stably protected from external moisture and the like, thereby allowing the first and second semiconductor devices 1002 and 1004 to operate more stably.

According to the embodiment of FIG. 13, the semiconductor package may include a circuit board 1100 and semiconductor devices 1102 and 1105 mounted on the circuit board 1100. The circuit board 1100 may be any one of the circuit boards described with reference to FIGS. 1a to 9, and for example may be the circuit board illustrated in FIG. 1a, but embodiments are not limited thereto.

The plurality of circuit layers provided in the circuit board 1100 may include a first mounting portion overlapping the cavity in the vertical direction and provided in the cavity, and a first bonding member 1101 may be disposed on the first mounting portion. Here, the first mounting portion is a pad for mounting the first semiconductor device 1102, and may be, for example, the first pad 111P1 illustrated in FIG. 1a. In addition, the first semiconductor device 1102 may be attached on the first bonding member 1101. Embodiments allow the first semiconductor device 1102 to be disposed in the cavity provided in the circuit board, thereby reducing a thickness in the vertical direction of the circuit board 1100 by a depth of the cavity.

In addition, the plurality of circuit layers provided in the circuit board may include a second mounting portion disposed on the via electrode, and second bonding members 1103 and 1104 may be disposed on the second mounting portion. In addition, the second semiconductor device 1105 may be attached on the second bonding member 1104. In this case, the second mounting portion may be a bonding portion respectively provided on the via electrode including the through hole and the via electrode not including the through hole, but embodiments are not limited thereto. In this case, a size of the via electrode may be smaller than a size of the second semiconductor device 1105.

In addition, the semiconductor package may further include a molding member 1106 molding the first and second semiconductor devices 1102 and 1105, thereby stably protecting the first and second semiconductor devices 1002 and 1105 from external moisture and the like, and accordingly allowing the first and second semiconductor devices 1002 and 1105 to operate more stably.

According to the embodiment of FIG. 14, the semiconductor package may include a circuit board 1200 and semiconductor devices 1204, 1206, and 1208 mounted on the circuit board 1200.

The circuit board 1200 includes a cavity, and the first semiconductor device 1204 may be attached in the cavity through a first bonding member 1203.

In addition, second and third semiconductor devices 1206 and 1207 may be mounted on the circuit board 1200 while being spaced apart from the first semiconductor device 1204 in the horizontal direction. The second and third semiconductor devices 1206 and 1207 may be provided while being spaced apart from each other in the horizontal direction on the circuit board 1200, but embodiments are not limited thereto. For example, the second and third semiconductor devices 1206 and 1207 may be stacked and disposed on the circuit board 1200 along the vertical direction. To this end, the circuit board 1200 may include circuit layers 1201 and 1202 electrically connecting the second and third semiconductor devices 1206 and 1207 to each other. In this case, the circuit board 1200 may have a structure in which a plurality of insulating layers are stacked along the vertical direction, and at least one insulating layer disposed closest to the second and third semiconductor devices 1206 and 1207 among the plurality of insulating layers may be provided as a second insulating layer. Accordingly, fine circuit layers may be disposed on the second insulating layer, and accordingly the second and third semiconductor devices 1206 and 1207 may be electrically connected to each other without a separate connection member. Specifically, in order to electrically connect the second and third semiconductor devices 1206 and 1207, a connection member such as a bridge die should be provided in the circuit board 1200, and the connection member may include a redistribution layer connecting the second and third semiconductor devices 1206 and 1207. In this case, embodiments make it possible to form, on the second insulating layer, a circuit layer corresponding to the redistribution layer provided in the connection member, and accordingly the second and third semiconductor devices 1206 and 1207 may be electrically connected to each other without a separate connection member. In this case, at least one among the circuit layers 1201 and 1202 provided in the circuit board 1200 includes a ground pattern, and the ground pattern may be connected to ground terminals provided in the second and third semiconductor devices 1206 and 1207. In this case, the ground pattern may function as a ground and may also function to improve rigidity of the circuit board. For example, the ground pattern may overlap the first semiconductor device 1204 in the horizontal direction, and accordingly may improve rigidity of the circuit board in a region in which the first semiconductor device 1204 is disposed.

In addition, second bonding members 1205 and 1207 may be disposed on the circuit board 1200, and the second and third semiconductor devices 1206 and 1207 may be attached on the second bonding members 1205 and 1207. The second and third semiconductor devices 1206 and 1207 may be electrically connected to each other through a circuit layer provided on the first insulating layer of the circuit board 1200. In addition, via electrodes including through holes may be provided in the circuit board 1200, and the via electrodes may vertically overlap the second and third semiconductor devices 1206 and 1207, respectively. For example, the via electrodes may include a first via electrode overlapping the second semiconductor device 1206 in the vertical direction and a second via electrode overlapping the third semiconductor device 1207 in the vertical direction, thereby further improving heat dissipation characteristics of the circuit board and semiconductor package with respect to heat generated from the second and third semiconductor devices 1206 and 1207.

In addition, referring to FIG. 15, the circuit board according to embodiments may be used as an interposer provided between a semiconductor package substrate and a semiconductor device. For example, the semiconductor package may include a circuit board 1300, and a plurality of semiconductor devices may be attached on the circuit board 1300. In this case, the circuit board 1300 may be an interposer provided between the semiconductor package substrate 1302 and the plurality of semiconductor devices.

The semiconductor package substrate 1302 is disposed on a lower surface of the circuit board 1300. The circuit board 1300 may include a pad portion connected to the semiconductor package substrate 1302, and a third bonding member 1301 may be disposed on a lower surface of the pad portion. In addition, the semiconductor package substrate 1302 may be electrically connected to the circuit board 1300 through the third bonding member 1301. The semiconductor package substrate 1302 may electrically connect a main board of an electronic device and the circuit board 1300.

Meanwhile, when the circuit board having the features of the invention described above is used in IT devices or home appliances such as smartphones, server computers, or TVs, functions such as signal transmission or power supply may be stably performed. For example, when the circuit board having the features of the present invention performs a semiconductor package function, it can safely protect a semiconductor chip from external moisture or contaminants, and can solve problems of leakage current, electrical short circuits between terminals, or electrical opening of terminals supplying power to the semiconductor chip. In addition, when performing a signal transmission function, a noise problem can be solved. Through this, the circuit board having the features of the invention described above allows stable functions of IT devices or home appliances to be maintained, and thus the entire product and the circuit board to which the present invention is applied may achieve functional integrity or technical interoperability with each other.

When the circuit board having the features of the invention described above is used in a transportation device such as a vehicle, it can solve a problem of distortion of signals transmitted to the transportation device, or can safely protect a semiconductor chip controlling the transportation device from the outside and solve problems of leakage current, electrical short circuits between terminals, or electrical opening of terminals supplying power to the semiconductor chip, thereby further improving stability of the transportation device. Accordingly, the transportation device and the circuit board to which the present invention is applied may achieve functional integrity or technical interoperability with each other.

The characteristics, structures and effects described in the embodiments above are included in at least one embodiment but are not limited to one embodiment. Furthermore, the characteristics, structures, and effects and the like illustrated in each of the embodiments may be combined or modified even with respect to other embodiments by those of ordinary skill in the art to which the embodiments pertain. Thus, it should be construed that contents related to such a combination and such a modification are included in the scope of the embodiment.

The description has been focused on the embodiment, but it is merely illustrative and does not limit the embodiment. A person skilled in the art to which the embodiment pertains may appreciate that various modifications and applications not illustrated above are possible without departing from the essential features of the embodiment. For example, each component particularly represented in the embodiment may be modified and implemented. In addition, it should be construed that differences related to such changes and applications are included in the scope of the embodiment defined in the appended claims.

## Claims

1. A circuit board comprising:
a first insulating layer;
a second insulating layer disposed on the first insulating layer and including a cavity;
a protective layer disposed on the second insulating layer; and
a via electrode including an upper surface located on a same plane as an upper surface of the second insulating layer, and penetrating at least a partial region of the second insulating layer from the upper surface of the via electrode toward a lower surface of the second insulating layer,
wherein the via electrode includes a through hole penetrating at least a partial region of the via electrode from the upper surface of the via electrode toward the lower surface of the second insulating layer, and
wherein the through hole of the via electrode overlaps the cavity provided in the second insulating layer in a horizontal direction.

2. The circuit board of claim 1, wherein the second insulating layer includes a first portion disposed at an outer side of the via electrode, and a second portion disposed in the through hole of the via electrode.

3. The circuit board of claim 1, wherein the through hole is provided in plurality and spaced apart from each other in the via electrode in a first horizontal direction and a second horizontal direction different from the first horizontal direction.

4. The circuit board of claim 2, wherein the second insulating layer includes a via hole penetrating at least a partial region of the second portion from an upper surface of the second portion toward a lower surface of the second portion, and
wherein the circuit board further comprises a sub via electrode disposed in the via hole of the second insulating layer.

5. The circuit board of claim 4, wherein the second portion of the second insulating layer surrounds the sub via electrode and is provided between an inner side surface of the through hole of the via electrode and an outer side surface of the sub via electrode.

6. The circuit board of claim 1, wherein the through hole of the via electrode is spaced apart from a perimeter of the upper surface of the via electrode.

7. The circuit board of claim 6, wherein the perimeter of the upper surface of the via electrode includes a plurality of curved portions and a plurality of linear portions provided between the plurality of curved portions, and
wherein the plurality of curved portions and the plurality of linear portions have a step along the horizontal direction.

8. The circuit board of claim 6, wherein the perimeter of the upper surface of the via electrode includes a plurality of first linear portions and a plurality of second linear portions provided between the plurality of first linear portions, and
wherein the plurality of first linear portions and the plurality of second linear portions have a step along the horizontal direction.

9. The circuit board of claim 1, wherein a sidewall of the cavity of the second insulating layer includes a first sidewall connected to the upper surface of the second insulating layer and having a first inclination, and a second sidewall provided between the lower surface of the second insulating layer and the first sidewall and having a second inclination different from the first inclination.

10. The circuit board of claim 1, wherein the second insulating layer includes a first-first insulating layer disposed on the first insulating layer, and a first-second insulating layer disposed on the first-first insulating layer, and
wherein the cavity and the via electrode are provided in at least one of the first-first insulating layer and the first-second insulating layer.
